# EUROPÄISCHE PATENTSCHRIFT

(11) **EP 1 705 975 B1**
(45) Veröffentlichungstag und Bekanntmachung des Hinweises auf die Patenterteilung: **19.09.2007**
(21) Anmeldenummer: 06003442.8
(22) Anmeldetag: 05.12.2003
(51) Int. Cl.: H05K 7/14

(54) **Messgerät**
Measuring apparatus
Appareil de mesure

(30) Priorität: 03.01.2003 DE 10300072; 12.06.2003 DE 10326388
(43) Veröffentlichungstag der Anmeldung: 27.09.2006
(62) Teilanmeldung aus: 03785748.9
(73) Patentinhaber: Rohde & Schwarz GmbH & Co. KG, 81671 München (DE)
(72) Erfinder: Müller, Torsten, 90513 Zirndorf (DE); Seitz, Birgit, 80637 München (DE); Hausdorf, Reiner, 85521 Ottobrunn (DE); Reckziegel, Rudolf, 01217 Dresden (DE)
(74) Vertreter: Körfer, Thomas

(56) Entgegenhaltungen:
- EP-A- 0 845 930
- DE-A1- 3 933 643
- US-A- 5 492 481
- US-A- 5 541 810

## Beschreibung

Die Erfindung betrifft ein Messgerät mit in ein Messgerätgehäuse einsteckbaren Messgerätmodulen.

Der Aufbau von Messgeräten aus mehreren in einem Gehäuse einsteckbaren Messgerätmodulen ist z. B. aus der Offenlegungsschrift DE 39 33 647 A1 bekannt. Das Messgerät wird dabei aus einem Gehäuse gebildet, in welches mehrere Steckbaugruppen eingesetzt werden. Die Steckbaugruppen kontaktieren gemeinsam eine Steckerplatte, über die eine elektrische Kontaktierung der einzelnen Steckbaugruppen erfolgt. Die einzelnen Steckbaugruppen ergänzen sich dabei in ihrer Funktion zu einem gesamten Messgerät.

Das Gehäuse ist so ausgebildet, dass der Einsatz in einem 19 Zoll Rack möglich ist, ohne dass die Steckbaugruppen aus dem Gehäuse entfernt und in ein solches 19 Zoll Rack eingesetzt werden müssen. Die Steckbaugruppen werden von der Vorderseite her in das Messgerät eingeschoben. Bei einem Einsatz des Gehäuses in ein 19 Zoll Rack sind damit sämtliche Anschlüsse der Steckbaugruppen ausschließlich von der Vorderseite her zugänglich. Soll das Messgerät dagegen als Tischgerät verwendet werden, so kann es mit einer auf der Rückseite des Messgeräts angeordneten Informationsausgabeeinrichtung als Funktionseinheit bestückt werden. Die Informationsausgabeeinrichtung erstreckt sich über die gesamte Breite des Messgeräts. Zur Bedienung ist das Messgerät dann so zu drehen, dass die Informationsausgabeeinrichtung dem Bediener zugewandt ist. Gleichzeitig werden dabei jedoch die Anschlüsse, welche an den einzelnen Steckbaugruppen angeordnet sind, von dem Bediener weg gedreht, so dass ein Anschließen von einer Messleitung beispielsweise lediglich auf der von dem Bediener abgewandten Seite möglich ist.

Die Messgerätmodule haben dabei den Nachteil, dass für jeden Modultyp ein eigenes Modul konstruiert werden muss, das für die benötigten elektronischen Komponenten den entsprechenden Bauraum bietet. Die Verwendung von Gleichteilen ist damit nur dann möglich, wenn bei Steckbaugruppen mit geringem Platzbedarf ein entsprechender Leerraum akzeptierbar ist.

Bei dem beschriebenen Messgerät ist nachteilig, dass auf der dem Bediener zugewandten Seite ein Anschließen einer Messleitung nicht möglich ist.

Ein weiterer Nachteil ist, dass ein mobiler Einsatz des Messgeräts nur bedingt möglich ist, da für die einzelnen Steckbaugruppen keine Schutzvorrichtung gegenüber Erschütterungen vorgesehen ist. Durch das Fehlen einer solchen Schutzvorrichtung gegenüber Erschütterungen, wie sie beispielsweise durch das Absetzen des Gerätes an einem Messplatz auftreten können, wird die Zuverlässigkeit des Messgerät erheblich reduziert.

Ein weiterer Nachteil ist, dass sich die einzelnen Steckbaugruppen bei dem vorgeschlagenen Gerät gegenseitig erst zu einer gesamten, funktionalen Einheit ergänzen. Dadurch ist es erforderlich, das Messgerät in seiner Gesamtheit, unter Einbeziehung sämtlicher zusammenwirkenden Steckbaugruppen zu kalibrieren. Ein Austausch einer einzelnen Steckbaugruppe ist ohne eine neue Kalibrierung des Messgeräts nicht möglich.

Es ist die Aufgabe der Erfindung, ein Messgerät mit einsteckbaren Messgerätmodulen zu schaffen, welches eine komfortable Bedienung von der Seite der Anzeigevorrichtung her durch einen Bediener ermöglicht.

Die Aufgabe wird durch das erfindungsgemäße Messgerät nach Anspruch 1 gelöst.

Ein einzelnes Messgerätmodul weist jeweils einen ersten Leiterplattenraum sowie einen zweiten Leiterplattenraum auf. Durch die Verwendung solcher voneinander abgeteilter Räume besteht die Möglichkeit, jene Komponenten, welche besonders im Hinblick auf ihr Hochfrequenzverhalten empfindlich sind, beispielsweise in dem ersten Leiterplattenraum anzuordnen, und diesen durch besondere Maßnahmen gegenüber elektromagnetischer Einstrahlung zu schützen. Dabei kann der Schutz auch auf der Leiterplatte selbst angeordnet sein, beispielsweise durch metallische Abdeckung der Komponenten. Damit wird eine offene Gestaltung des Messgerätmoduls möglich, was zu einer besseren Führung des Kühlluftstroms führt.

Weiterhin ist es vorteilhaft, das Messgerätmodul aus zumindest einem Rahmenelement aufzubauen, dessen äußerer Umfang die innerhalb angeordnete Leiterplatte im wesentlichen geschlossen umgibt. Durch die Verwendung von Rahmenelementen ist es möglich, mit einem hohen Maß an Symmetrie ein variables System zu erzeugen, wodurch die Produktionskosten durch die kleine Anzahl verschiedener zu fertigender Teile gering gehalten werden.

Gemäß Anspruch 1 weist das Messgerät an seiner Vorderseite eine Informationsausgabeeinrichtung auf, wobei auf der Vorderseite des Messgeräts zudem eine Aussparung vorgesehen ist, die einen Zugang zu einem elektrischen Anschluss ermöglicht. Über diesen elektrischen Anschluss ist beispielsweise eine Messleitung mit einem der in das Messgerät eingesteckten Messgerätmodule zu verbinden. Dabei ergibt sich der Vorteil, dass der Austausch einer Messleitung, beispielsweise bei einem Wechsel des zu vermessenden Gerätes, erfolgen kann, ohne dass das Messgerät hierzu umgedreht werden müsste, um an eine der rückwärtigen Anschlussmöglichkeit zu gelangen.

Durch die in den Unteransprüchen aufgeführten Maßnahmen sind vorteilhafte Weiterbildungen des erfindungsgemäßen Messgeräts sowie der erfindungsgemäßen Messgerätmodule möglich.

Insbesondere ist es vorteilhaft, dass zusätzlich zu den auf der Vorderseite des Gerätes angeordneten Anschlüssen an der Geräterückseite weiterer Anschlüsse als Ein- oder Ausgänge vorgesehen sind, welche an den einzelnen Messgerätmodulen angeordnet sind. Dadurch ist es möglich, diejenigen Anschlüsse, welche durch den Bediener häufig mit unterschiedlichen Leitungen verbunden werden müssen, auf der Vorderseite des Messgeräts anzuordnen, andere Anschlüsse dagegen, welche nur seltener gebraucht werden, können dagegen auf der Rückseite angeordnet sein, wodurch an der Vorderseite des Messgeräts eine große Fläche verfügbar ist, welche entweder zur Anordnung von Bedienungselementen oder für ein größeres Display zur Verfügung steht.

Vorteilhaft ist es außerdem, die Messgerätmodule mittels einer Führungseinrichtung in dem Messgerät aufzunehmen, wobei die Führungseinrichtung über zumindest ein elastisch verformbares Führungselement verfügt, welches geeignet ist, die Härte eines auf ein Messgerätmodul wirkenden Stoßes aufgrund einer Erschütterung zu reduzieren. Durch die entsprechend reduzierten Beschleunigungen, welche auf alle in dem jeweiligen Messgerätmodul enthaltenen Bauteile wirken, wird die Zuverlässigkeit sowie die Lebensdauer des Messgerät erheblich verbessert.

Das Rastermaß der Führungseinrichtungen ist dabei vorteilhafterweise so gewählt, dass zwischen jeweils benachbarten Messgerätmodulen im Bereich der ersten Leiterplattenräume ein geringfügiger Abstand ausgebildet wird, durch den ein Luftstrom zur Kühlung der Messgerätmodule geführt wird. Um ein Verkippen oder eine Drehbewegung der eingesteckten Messgerätmodule zu verhindern, werden die Führungselemente bevorzugt aus einer Anzahl von in Reihe angeordneten Federzungen gebildet.

Um zu verhindern, dass die sich bei einer Erschütterung bewegenden Messgerätmodule zu einer Zerstörung der Anschlusskontaktbuchsen, die an der Steckerplatte ausgebildet sind, führen, und um Toleranzen auszugleichen, ist die Steckerplatte schwimmend in dem Messgerätgehäuse gelagert. Die Lagerung erfolgt dabei bevorzugt so, dass ein Verschieben der Steckerplatte nur unter Aufbringung einer gewissen Reibungskraft erfolgen kann, so dass eine Erschütterung des gesamten Messgeräts zu einer stark Dämpfung der Bewegung der einzelnen Messgerätmodule führt.

Die Messgerätmodule sind besonders bevorzugt als in sich geschlossene funktionale Einheiten ausgebildet. Dies bedeutet, dass jedes Messgerätmodul den vollständigen Funktionsumfang eines Messgeräts aufweist. Die Anschlüsse, über die die Kontaktierung eines Messgerätmoduls erfolgt, dienen dabei einerseits dem Anschluss eines zu vermessenden Gerätes oder einer zu vermessenden Baugruppe, andererseits dem Anschluss des Messgerätmoduls an ein Bussystem, welches gemäß einer bevorzugten Ausführungsform auf der Steckerplatte vorgesehen ist. Über dieses Bussystem werden die von einem Messgerätmodul erzeugten Daten zur weiteren Verarbeitung anderen Messgerätmodulen oder auch externen Rechnersystemen zur Weiterverarbeitung zugeführt. Neben der Übermittlung von Parametersätzen zur Durchführung einer Messung an das jeweilige Messgerätmodul dient das Bussystem dabei auch zur Versorgung der Messgerätmodule mit elektrischer Energie. Hierzu ist, ebenfalls über einen Steckkontakt mit der Steckerplatte verbunden, ein Netzmodul vorgesehen, welches ebenfalls als ein steckbares Modul ausgeführt ist und von dem verwendeten Rastermaß der Messgerätmodule Gebrauch macht, dabei allerdings mehrere Rastereinheiten benötigt.

Weiterhin ist es vorteilhaft, dass jeweils ein Grundelement eines Messgerätmoduls mit einem weiteren Grundelement so verbunden werden kann, dass der jeweils zweite Leiterplattenraum der beiden verbundenen Grundelemente einem gemeinsamen Hilfsleiterplattenraum ausbildet. Dabei ist der jeweils erste Leiterplattenraum ein separater, geschlossener Raum für jedes Grundelement, der lediglich eine oder mehrere lokal begrenzte Öffnungen zu Durchführung von Teilen einer Hauptleiterplatte aufweist. In diesem jeweils erste Leiterplattenraum wird jeweils eine Hauptleiterplatte aufgenommen, wobei die Verbindung der beiden Hauptleiterplatte dann bevorzugt über eine in dem Hilfsleiterplattenraum angeordnete Hilfsleiterplatte erfolgt. Die beiden Grundelemente bilden somit, verbunden über eine Hilfsleiterplatte in dem Hilfsleiterplattenraum, gemeinsam ein Messgerätmodul aus, welches in das Messgerät eingesteckt wird. Ebenso können die beiden Hauptleiterplatten in dem Hilfsleiterplattenraum über ein Kabel verbunden werden oder eine direkte Steckverbindung aufweisen.

An Stelle des zweiten Grundelements kann außerdem durch das Verbinden eines Grundelements mit einem Rahmenkörper der zweite Leiterplattenraum ebenfalls zu einem Hilfsleiterplattenraum ergänzt werden, wobei durch den Hilfsleiterplattenraum ein vergrößerter Bereich zur Verfügung steht, in dem die Hauptleiterplatte des Messgerätmoduls kontaktiert wird.

Gegenüberliegend einer solchen, auf Seiten des zweiten Leiterplattenraums vorgesehenen Anschlussmöglichkeit, wird vorteilhafterweise ein Anschlussträger an dem Grundelement vorgesehen, an dem eine zusätzliche elektrische Anschlussmöglichkeit angeordnet ist. Während die Anschlüsse, welche im Bereich des zweiten Leiterplattenraums vorgesehen sind, zur Geräterückseite hin orientiert sind, wird die zusätzliche elektrische Anschlussmöglichkeit durch den Anschlussträger so weit in Richtung der Vorderseite des Messgeräts positioniert, dass sie beim Einsetzen des Messgerätmoduls durch die Aussparung in der Vorderseite des Geräts gesteckt wird und von der Vorderseite aus bedienbar ist.

Bei der Ausbildung des Grundelements aus zwei Rahmenelementen, welche gemeinsam zu einem Grundrahmen verbunden werden können, ist es besonders vorteilhaft, die Rahmenelemente mit Zentrierelementen zu versehen, auf denen die Hauptleiterplatte in dem Grundrahmen zentriert ist. Bei der Montage des zweiten Rahmenelements wird die Leiterplatte zwischen den beiden Rahmenelementen fixiert.

Die Verbindung zwischen einem Messgerätmodul und der Steckerplatte erfolgt vorzugsweise mittels eines steckbaren Kontaktelements, welches als Teil der Hauptleiterplatte ausgebildet ist und aus dem ersten Leiterplattenraum über eine entsprechende Ausnehmung in dem Grundrahmen herausgeführt wird. Die vorzugsweise als Gußteile hergestellten Rahmenelemente werden hierzu ausgefräst, wobei bei zusammengesetzten Grundrahmen vorzugsweise nur eine Ausfräsung in einem Rahmenelement ausgebildet wird, so dass eine zur Aufnahme einer HF-Dichtung vorgesehene Nut nicht durchbrochen werden muss.

Als Rahmenelemente werden bevorzugt solche Rahmen verwendet, welche zu beiden Seiten der Oberfläche der Hauptleiterplatte offen sind. Der aus zwei solchen Rahmenelementen gebildete Grundrahmen wird dann mittels Deckelplatten zu einem geschlossenen Grundelement ergänzt. Zur besseren Kühlung können die verwendeten Deckelplatten mit Löchern versehen sein, durch welche die Kühlluft in das Messgerätmodul einströmen kann. Zur Befestigung der Deckelplatten an dem Grundrahmen sind Klammerelemente vorgesehen, welche nach Auflegen der Deckelplatten auf dem Grundrahmen vom äußeren Umfang des Grundrahmens her über die Deckelplatten geschoben werden. Der Grundrahmen sowie die Deckelplatten werden damit durch das Aufsetzen der Klammerelemente zu einem Grundelement verbunden, wobei die Klammerelemente über Rastnasen verfügen, welche in entsprechende Vertiefungen, die in den Deckelplatten als Sicken vorgesehen sind, eingreifen. Damit wird ein unbeabsichtigtes Lösen der unter einer Federspannung stehenden Klammerelemente verhindert.

Die Klammerelemente weisen weiterhin eine Fläche auf, die nach dem Aufsetzen der Klammerelemente im Bereich des äußeren Umfangs des Grundrahmens angeordnet ist und an der zumindest ein Führungselement ausgebildet ist. Dieses Führungselement wirkt mit einem entsprechenden, an dem Messgerät ausgebildeten Führungselement zu einer Führungsvorrichtung zusammen.

Ausführungsbeispiele des erfindungsgemäßen Messgerät sowie der Messgerätmodule sind in der Zeichnung dargestellt und werden nachfolgend erläutert. Es zeigen:
- Fig. 1: eine schematische Darstellung einer Ansicht der Vorderseite eines erfindungsgemäßen Messgeräts;
- Fig. 2: eine perspektivische Darstellung einer Aufnahmevorrichtung des Messgeräts;
- Fig. 3: eine perspektivische Darstellung der Aufnahmevorrichtung mit abgenommenen Gehäusebauteilen;
- Fig. 4: eine perspektivische Darstellung der Aufnahmevorrichtung mit herausgenommenen Messgerätmodulen;
- Fig. 5: eine perspektivische Darstellung der Aufnahmevorrichtung mit herausgenommenen Blindelementen;
- Fig. 6: eine schematische Darstellung des Aufbaus eines ersten Messgerätmoduls;
- Fig. 7: eine schematische Darstellung des Aufbaus eines zweiten ersten Messgerätmoduls;
- Fig. 8: eine schematische Darstellung des Aufbaus eines ersten Messgerätmoduls aus zwei Grundelementen für ein erfindungsgemäßes Messgerät;
- Fig. 9: eine schematische Darstellung des Aufbaus eines zweiten Messgerätmoduls aus zwei Grundelementen für ein erfindungsgemäßes Messgerät;
- Fig. 10: eine schematische Darstellung des Aufbaus eines ersten Messgerätmoduls mit Abstandselementen für ein erfindungsgemäßes Messgerät;
- Fig. 11: eine schematische Darstellung eines dritten Messgerätmoduls aus zwei Grundelementen für ein erfindungsgemäßes Messgerät;
- Fig. 12: eine schematische Darstellung eines dritten Messgerätmoduls aus zwei Grundelementen aus einer zweiten Perspektive für ein erfindungsgemäßes Messgerät;
- Fig. 13: eine schematische Darstellung eines vierten Messgerätmoduls für ein erfindungsgemäßes Messgerät;
- Fig. 14: eine schematische Darstellung des Aufbaus eines fünften Messgerätmoduls mit einem Rahmenkörper für ein erfindungsgemäßes Messgerät; und
- Fig. 15: eine schematische Darstellung des Aufbaus eines fünften Messgerätmoduls mit einem Rahmenkörper aus einer zweiten Perspektive für ein erfindungsgemäßes Messgerät.

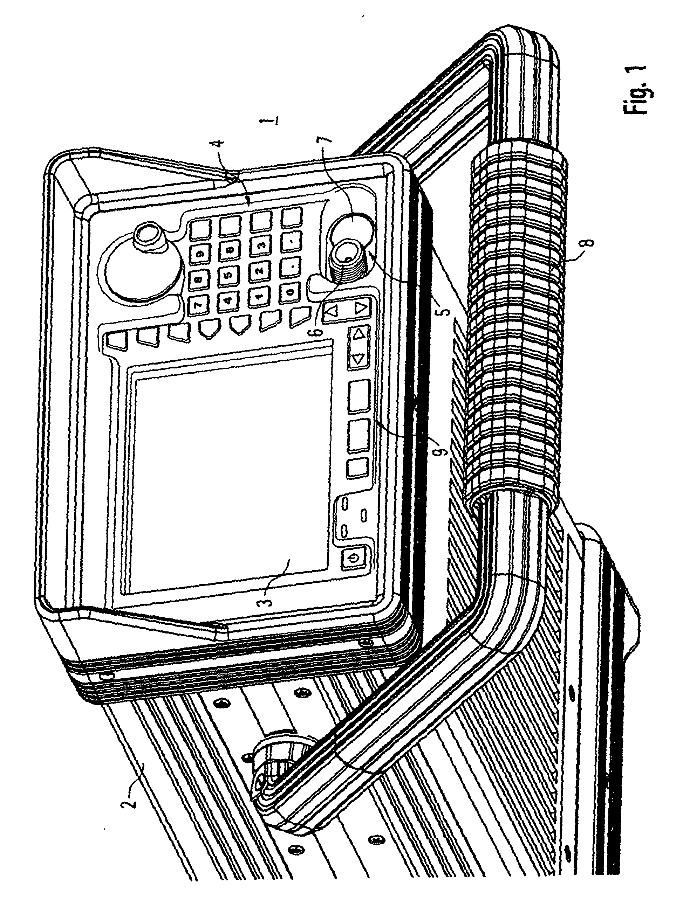

Ein Ausführungsbeispiel für ein erfindungsgemäßes Messgerät ist in Fig. 1 dargestellt. Das erfindungsgemäße Messgerät 1 umfasst ein Messgerätgehäuse 2, an dessen Vorderseite eine Informationsausgabeeinrichtung 9 angeordnet ist. In der Informationsausgabeeinrichtung 9 ist eine Anzeigevorrichtung 3 integriert. Zur Bedienung des Messgeräts 1 sind weiterhin in der nicht durch die Anzeigevorrichtung 3 benötigten Fläche an der Vorderseite des Meßgeräts 1 in der Informationsausgabeeinrichtung 9 mehrere Bedienelemente 4 angeordnet, durch die verschiedene Parameter zur Durchführung einer Messung eingestellt werden oder unterschiedliche Funktionen aufgerufen werden können. Weiterhin ist in der Vorderseite des Messgeräts 1 eine Aussparung 5 vorgesehen, über die ein elektrischer Anschluss 6 zugänglich ist.

Der elektrischer Anschluss 6 ist, wie nachfolgend noch ausführlich beschrieben wird, an einem der in das Messgerät 1 einsteckbaren Messgerätmodule angeordnet und steht nach der Montage des Messgerätmoduls durch die Aussparung 5 in der Vorderseite des Messgerät 1 hervor. Im dargestellten Ausführungsbeispiel des erfindungsgemäßen Messgeräts 1 ist die Aussparung 5 groß genug, um für einen zweiten elektrischen Anschluss, der an einem weiteren in das Gerät eingesteckten Messgerätmodul vorgesehen sein kann, eine Zugangsmöglichkeit zu schaffen. Im dargestellten Ausführungsbeispiel kann die entsprechende, in der Frontplatte des Messgerätes 1 vorgesehenen Öffnung mit einem Blindstopfen 7 verschlossen sein.

Weiterhin ist an dem Messgerätgehäuse 2 ein Handgriff 8 angeordnet, welche an dem Seitenflächen des Messgeräts 1 über eine Klemmvorrichtung in einer Schiene fixierbar ist. Der Haltegriff 8 kann über die Klemmvorrichtung in nahezu jeder beliebigen Position festgestellt werden, so dass er gleichzeitig als Stütze für das Messgerät 1 dient, über die das Messgerät in seiner Neigung einstellbar ist.

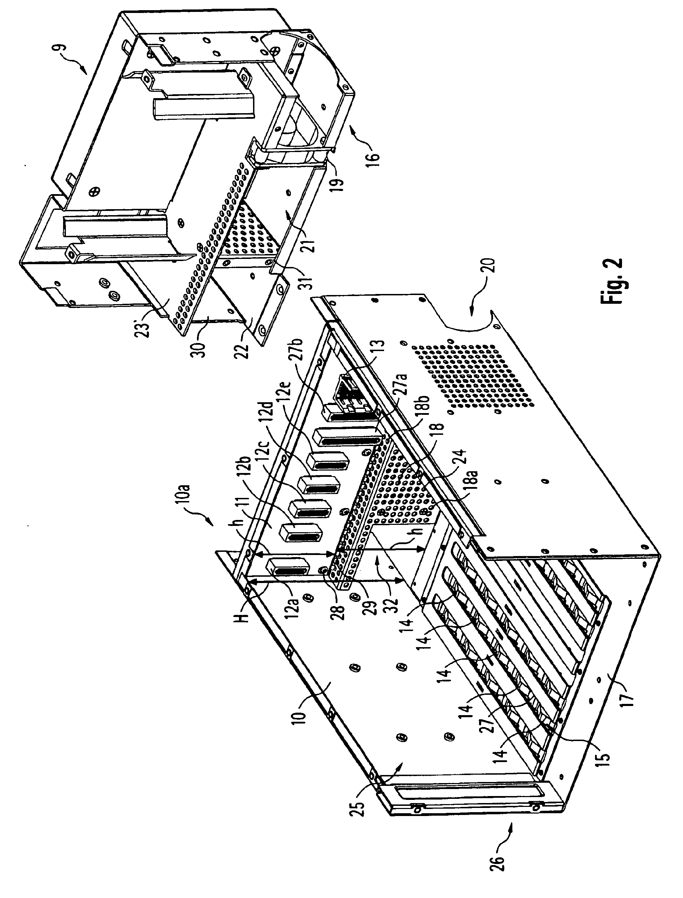

In Fig. 2 ist das Innere des Messgeräts 1 dargestellt. Die an der Vorderseite des Messgerätgehäuses 2 angeordnete Informationsausgabeeinrichtung 9 ist zur besseren Übersichtlichkeit abgenommen dargestellt. In dem Messgerätgehäuse 2 ist eine Aufnahmevorrichtung 10 angeordnet, an deren Vorderseite 10a die Informationsausgabeeinrichtung 9 befestigt wird. Die Informationsausgabeeinrichtung 9 ist dabei mit einem Bedienfrontträger 16 verschraubt und wird gemeinsam mit diesem an der Aufnahmevorrichtung 10 fixiert. Mittels des Bedienfrontträgers 16 ist die Informationsausgabeeinrichtung 9 mit einem Abstand zu einer Steckerplatte 11 angeordnet, welche im dargestellten Ausführungsbeispiel parallel zu der Vorderseite des Messgeräts 1 in der Aufnahmevorrichtung 10 angeordnet ist.

Die Höhe h der Steckerplatte 11 ist dabei deutlich geringer als die gesamte Bauhöhe H der Aufnahmevorrichtung 10. Die Steckerplatte 11 ist in einem oberen Bereich der Aufnahmevorrichtung 10 angeordnet. In Verlängerung der Steckerplatte 11 in Richtung des Bodens 17 der Aufnahmevorrichtung 10 ist ein Luftleitblech 18 angeordnet. Das Luftleitblech 18 trennt gemeinsam mit der Steckerplatte 11 das gesamte Bauvolumen des Messgerätgehäuses 2 in einen vorderen und einen hinteren Bereich auf.

In einem unteren Bereich des Bedienfrontträgers 16 ist ein Ventilator 19 angeordnet, der über einen Kühllufteinlass 20, der in einer Seitenwand des Messgeräts 1 vorgesehen ist, Umgebungsluft zur Kühlung der elektronischen Bauteile des Messgeräts 1 in einen Kühlluftschacht 21 fördert. Der Kühlluftschacht 21 wird zur Gehäuseunterseite hin durch ein Bodenblech 22 des Bedienfrontträgers 16 und zu Oberseite hin durch einen Zwischenblech 23 begrenzt. Das Zwischenblech 23 befindet sich dabei in auf der Höhe des Übergangs zwischen der Steckerplatte 11 und dem Luftleitblech 18.

Das Luftleitblech 18 weist eine Vielzahl von Öffnungen 24 auf, über die der Kühlluftschacht 21 mit einem Modulbereich 25 im hinteren Teil der Aufnahmevorrichtung 10 verbunden ist. Die mittels des Ventilators 19 aus der Umgebung des Messgeräts 1 angesaugte Luft wird in dem Kühlluftschacht 21 gestaut. Ein Druckausgleich erfolgt über die Öffnungen 24 in Richtung des Modulbereichs 25, so dass der Modulbereich 25 regelmäßig mit frischer Kühlluft versorgt wird. Durch den so entstehenden Luftstrom werden die in dem Modulbereich 25 angeordneten elektronischen Komponenten der Messgerätmodule gekühlt. Um eine Luftstrom zur Kühlung der Messgerätmodule nicht nur in dem unteren Bereich des Messgeräts 1 zu erzeugen, ist das Luftleitblech 18 abgewinkelt ausgeführt, wodurch ein vertikaler Abschnitt 18a und ein horizontaler Abschnitt 18b entsteht. Über den horizontalen Abschnitt 18b wird die Kühlluft aus dem Kühlluftschacht 21 auch in den Bereich der Steckerplatte 11 geblasen.

Um zumindest für einen Teil der eingesteckten Messgerätmodule auch einen von der Informationsausgabeeinrichtung 9 zugänglichen elektrischen Anschluss vorsehen zu können, ist der Kühlluftschacht in Richtung einer Seitenwand 30 des Bedienfrontträgers 16 durch ein Lochblech 31 begrenzt. Zwischen der Seitenwand 30 und dem Lochblech 31 ist das Luftleitblech 18 entsprechend ausgeschnitten, so dass eine Durchgangsöffnung 32 geschaffen wird, durch die die bereits erläuterten, von der Vorderseite des Messgeräts zugänglichen elektrischen Anschlüsse der Messgerätmodule gesteckt werden können.

An dem Boden 17 der Aufnahmevorrichtung 10 ist für jedes der einsteckbaren Messgerätmodule eine Führungseinrichtung 15 ausgebildet, in welche ein einzelnes Messgerätmodul von der offenen Rückseite 26 der Aufnahmevorrichtung 10 eingeführt werden kann. Die Führungseinrichtung 15 umfasst dabei eine Nut 27, die der seitlichen Führung eines Messgerätmoduls dient. Ferner weist die Führungseinrichtung 15 mehrere Federzungen 14 auf, welche in der Nut 27 angeordnet sind. Die Federzungen 14 halten das eingesetzte Messgerätmodul in einem definierten Abstand zu dem Boden 17 der Aufnahmevorrichtung 10. Wirkt auf das eingesetzte Messgerätmodul eine Kraft, beispielsweise beim Abstellen des Messgeräts auf einem Tisch, so werden die Federzungen 14 elastisch verformt und damit der Stoß auf das Messgerätmodul reduziert. Die Führungseinrichtungen 15 der Aufnahmevorrichtung wirken zur Führung der Messgerätmodule mit an den Messgerätmodulen angeordneten Führungselementen zusammen, die nachstehend noch beschrieben werden.

Zum Datenaustausch ist das eingesteckte Messgerätmodul mit der Steckerplatte 11 über jeweils eine Steckverbindung verbunden, wobei auf der Steckerplatte 11 hierzu mehrere Steckerbuchsen 12a bis 12e vorgesehen sind. Zusätzlich zu dieser Anzahl von Steckerbuchsen 12a bis 12e können an der Steckerplatte 11 weiterer Steckerbuchsen 27a und 27b vorgesehen sein, welche z. B. zur Kontaktierung eines Rechnermoduls dienen. Die Steckerplatte 12a bis 12e sowie die weiteren Steckerbuchsen 27a, 27b sind Teil eines Bussystems, welches auf der Steckerplatte 11 ausgebildet ist. Das Bussystem wird dabei über einen ebenfalls in die Aufnahmevorrichtung 10 eingestecktes Rechnermodul gesteuert. Der Abstand der Steckerbuchsen wird von dem Rastermaß vorgegeben, in dem die Führungseinrichtungen ausgebildet sind, wobei abweichend hiervon die Steckerbuchsen 12a und 12b einen größeren Abstand aufweisen, um die Durchführung der elektrischen Anschlüsse zur Vorderseite des Messgeräts 1 zu ermöglichen.

Die Messgerätmodule verfügen ihrerseits über keine eigene Stromversorgung, sondern werden über das auf der Steckerplatte 11 ausgebildete Bussystem durch eine gemeinsame Strom- und Spannungsversorgung mit elektrischer Energie versorgt. Hierzu ist an der Steckerplatte 11 ein weiteres Steckerelement 13 ausgebildet, durch welches die Steckerplatte 11 mit einem in der Fig. 2 nicht dargestellten Netzmodul verbunden wird. Das Netzmodul stellt damit über die Steckerplatte 11 die erforderliche elektrischer Energie für sämtliche in dem Messgerät 1 angeordneten elektrischen und elektronischen Komponenten einschließlich der Informationsausgabeeinrichtung 9 zur Verfügung.

Die Kommunikation zwischen einer an das Messgerät 1 angeschlossenen Ein-/Ausgabevorrichtung bzw. der Informationsausgabeeinrichtung 9 und den einzelnen Messgerätmodulen erfolgt ausschließlich über das auf der Steckerplatte 11 ausgebildete Bussystem. Vorzugsweise kann hierbei ein USB-System (Universal Serial Bus) verwendet werden. Die Steckerplatte 11 ist in der Aufnahmevorrichtung 10 schwimmend gelagert. Zur Fixierung der Steckerplatte 11 dienen dabei Schrauben 28, welche durch eine erweiterte Ausnehmung in der Steckerplatte 11 hindurch mit einem an der Aufnahmevorrichtung 10 fixierten, in der Figur von der Steckerplatte 11 verdeckten, Bauteil verschraubt sind. Durch die erweiterte Ausnehmung der Steckerplatte 11 kann sich die Steckerplatte 11 in gewissen Grenzen relativ zu der Aufnahmevorrichtung 10 verschieben. Zusätzlich wird die Steckerplatte 11 von einer Klemmleiste 29 gehalten. Die Klemmleiste 29 besteht aus einer in Reihe angeordneten Anzahl von Federlaschen, die die Steckerplatte 11 zusätzlich fixieren und die über die Klemmkraft eine zu leichte Verschiebung der Steckerplatte 11 verhindern. Die bei einer Verschiebung erzeugte Reibung dämpft die Bewegung der Steckerplatte 11 und damit auch der darin eingesteckten Messgerätmodule.

Erfolgt auf Grund der Führungseinrichtung 15 eine Verschiebung eines Messgerätmoduls relativ zu der Aufnahmevorrichtung 10, so kann die Steckerplatte 11, die mit den Messgerätmodulen über die jeweilige Steckerbuchse 12a bis 12e bzw. über die weiteren Steckerbuchse 27a, 27b verbunden ist, der Bewegung der eingesteckten Messgerätmodule folgen. Dabei muss die Steckerplatte 11 in der Klemmleiste 29 Reibungsarbeit verrichten, wodurch die Bewegung der eingesetzten Messgerätmodule gedämpft wird.

Die Führungseinrichtung 15 ist vorzugsweise symmetrisch aufgebaut, so dass in die in der Fig. 2 nicht dargestellten Abdeckung der Aufnahmevorrichtung 10 jeweils entsprechend ausgebildete Federzungen 14 sowie Nuten 27 eingebracht sind. Insgesamt sind in der Aufnahmevorrichtung 10 zehn Steckplätze vorgesehen, wobei fünf der Steckplätze zur Aufnahme von Messgerätmodulen vorgesehen sind, zwei Steckplätze zur Aufnahme eines Rechnermoduls und die übrigen drei Steckplätze für ein Netzmodul reserviert sind. Im Bereich des Netzmoduls wird auf eine Ausbildung von einer Führungseinrichtung 15 mit Federzungen 14 verzichtet. Die einzelnen Messgerätmodule können in unterschiedlichen Breiten aufgebaut sein, so dass auch mehrere Steckplätze durch ein einziges Messgerätmodul belegt sein können.

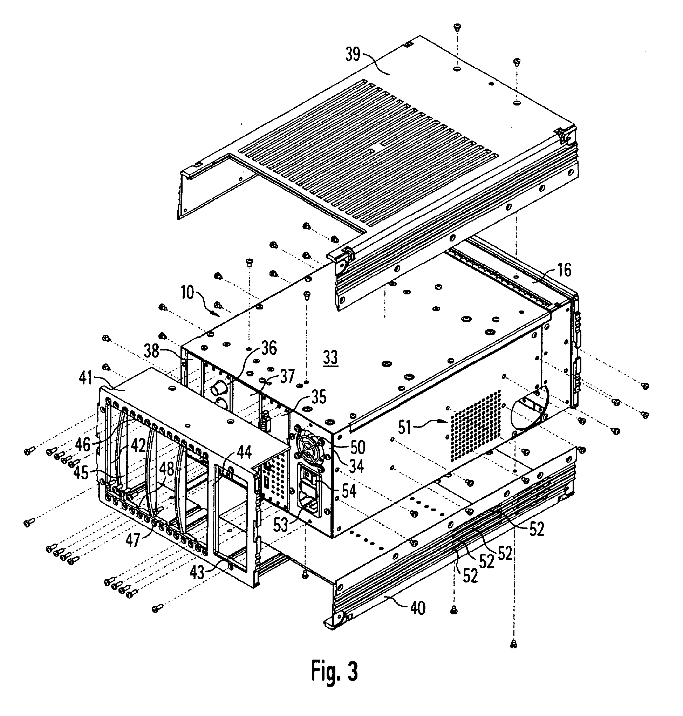

In Fig. 3 ist noch einmal die Aufnahmevorrichtung 10 dargestellt, wobei hier zusätzlich die Abdeckung 33 aufgesetzt ist. Zudem ist der Bedienfrontträger 16 auf die Aufnahmevorrichtung 10 aufgesetzt. Die Aufnahmevorrichtung 10 ist beispielhaft bestückt mit einem Netzmodul 34 und zwei Messgerätmodulen 35 und 36, wobei das Messgerätmodul 35 als Rechnermodul ausgeführt ist. Der an der Rückseite der Aufnahmevorrichtung 10 verbleibende Raum zwischen den Messgerätmodulen 35 und 36 ist mit Blindelementen 37 und 38 ausgeführt. Das Netzmodul 34 sowie die Messgerätmodule 35 und 36 bilden damit zusammen mit den Blindelementen 37 und 38 eine ausgefüllte Rückseite der Aufnahmevorrichtung 10 aus. Die Blindelemente 37 und 38 berühren dabei mit nachfolgend noch beschriebenen Lamellen die Messgerätmodule 35 und 36 bzw. die Seitenwand der Aufnahmevorrichtung 10 und tragen damit zu einer Abschirmung der Messgerätmodule bezüglich elektromagnetischer Einstrahlung bei.

Zum Ausbilden einer einheitlichen Optik und eines massiven Gehäuses für das Messgerät 1 wird auf die Aufnahmevorrichtung 10 ein Gehäuseoberteil 39 aufgesetzt, welches zusammen mit einem Gehäuseunterteil 40 das von außen sichtbare Messgerätgehäuse 2 des Messgeräts 1 bildet. Die Messgerätmodule 35 und 36 sowie das Netzmodul 34 werden in der Aufnahmevorrichtung 10, in die die Messgerätmodule zunächst lediglich eingesteckt sind, mittels eines rückseitigen Messgerätgehäusedeckels 41 fixiert. Der rückseitige Messgerätgehäusedeckel 41 weist eine Öffnung 42 auf, durch die die zur Rückseite der Aufnahmevorrichtung 10 hin orientierten Seiten der Messgerätmodule 35 und 36 sowie das Netzmodul 34 zugänglich sind. Für das Netzmodul 34 ist dabei zweite Öffnung 43 vorgesehen, welche von der Öffnung 42 für die Messgerätmodule 35 und 36 durch einen Steg 44 getrennt ist.

Zum Abdecken der sichtbaren Übergänge zwischen den Messgerätmodulen 35 und 36 und den Blindelementen 37 und 38 werden in den rückwärtigen Messgerätgehäusedeckel 41 Einlegeelemente 45 eingesetzt. Hierzu sind an einem oberen Rand 46 und einem unteren Rand 47 der Öffnung 42 Aufnahmeaussparungen 48 ausgebildet, in die die Einlegeelemente 45 eingesetzt werden. Durch die Einlegeelemente 45 werden die zwischen den Messgerätmodulen 35 und 36 und den Blindelementen 37 und 38 entstehenden Spalte abgedeckt, so dass bei aufgesetztem rückwärtigen Gehäusedeckel 41 ein optisch homogener Gesamteindruck des Messgeräts 1 entsteht.

Das Netzmodul 34 verfügt im Gegensatz zu den übrigen Messgerätmodulen über eine eigene Kühlung. Hierzu ist an der Rückseite des Netzmoduls 34 ein Lüfter 50 angebracht, der einen Kühlluftstrom durch das Innere des Netzmoduls 34 strömen lässt, wobei für den Kühlluftstrom seitlich Eintrittöffnungen 51 vorgesehen sind. Die Eintrittöffnungen 51 sind in einer Seitenwand der Aufnahmevorrichtung 10 angeordnet. In dem Gehäuseunterteil 40 sind an einer korrespondierenden Stelle Schlitze 52 ausgebildet. Weiterhin ist an der Rückwand des Netzmoduls 34 ein Netzanschluss 53 vorgesehen, über den das Messgerät 1 mit einem Netzkabel verbindbar ist. Zum Ein- und Ausschalten des Messgeräts 1 ist ein Hauptschalter 54 vorgesehen. Der Hauptleitung 54 dient dabei zum vollständigen Abschalten des Geräts. Während einer normalen Betriebsunterbrechung kann das Messgerät 1 dagegen über einen an der Vorderseite angeordneten Standby-Schalter ein- und ausgeschaltet werden.

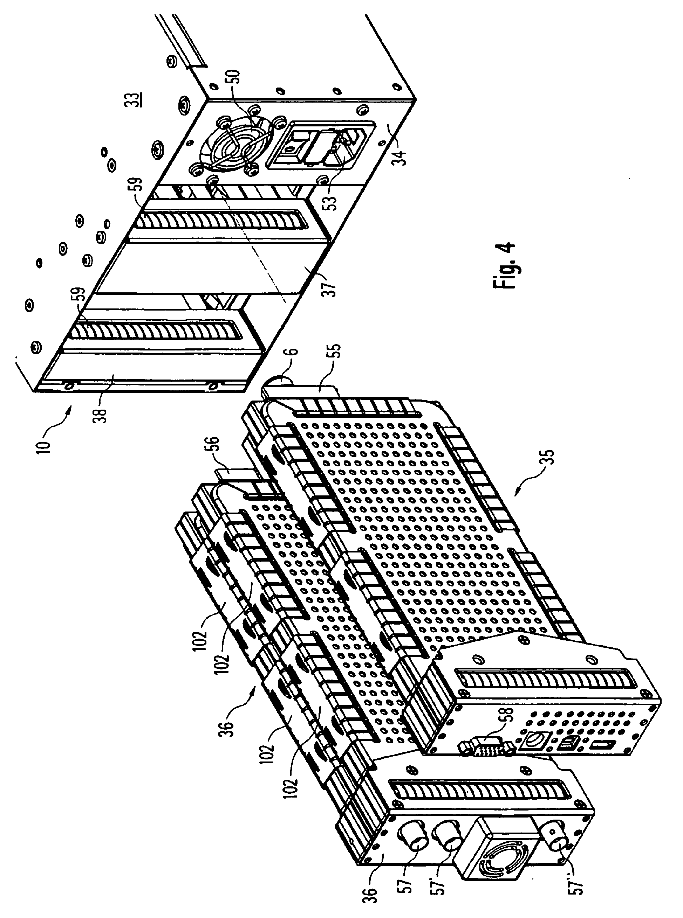

In Fig. 4 ist noch einmal die Aufnahmevorrichtung 10 dargestellt, wobei die Messgerätmodule 35 und 36 aus dem Messgerät herausgezogen dargestellt sind. Die Messgerätmodule 35 und 36 werden jeweils über eine Kontaktleiste 55 bzw. 56 mit einer der Steckerbuchsen 12a bis 12e bzw. 27a, oder 27b verbunden. An der der Kontaktleiste 56 des Messgerätmoduls 36 gegenüberliegenden Seite des Messgerätmoduls 36, die zur Rückseite des Messgeräts orientiert ist, sind elektrische Anschlüsse 57, 57' und 57'' ausgebildet, die Ein- oder Ausgänge des jeweiligen Messgerätmoduls sein können. Das Messgerätmodul 36 ist zur Verarbeitung von Messsignalen vorgesehen, die von dem zu vermessenden Prüfling (DUT) stammen. Die zu vermessenden Geräte werden hierzu beispielsweise mit einem der Anschlüsse 57, 57' oder 57'' verbunden. Die Verarbeitung eines solchen Messsignals erfolgt vollständig in dem Messgerätmodul 36. Die Parameter, welche zum Bearbeiten eines solchen ankommenden Signals erforderlich sind, werden dem Messgerätmodul 36 über das Bussystem der Steckerplatte 11 und die Kontaktleiste 56 zugeführt.

Das Vermessen eines solchen Prüflings führt zur Ausgabe eines Datensatzes durch das Messgerätmodul 36, wobei der Datensatz über die Kontaktleiste 56 durch das Messgerätmodul 36 und das Bussystem der Steckerplatte 11 anderen Messgeräten oder der Informationsausgabeeinrichtung 9 zur Anzeige zur Verfügung gestellt wird. Zusätzlich zu den elektrischen Anschlüssen 57, 57' und 57'' an der Rückseite des Messgeräts 1 ist in den dargestellten Ausführungsbeispiel der aus Fig. 1 bekannte elektrische Anschluss 6 an dem Messgerätmodul 36 ausgebildet, welcher von der Vorderseite des Messgeräts 1 zugänglich ist. Sowohl der elektrische Anschluss 6 als auch die elektrischen Anschlüsse 57, 57' und 57" dienen dem Eingang und Ausgang von Signalen, die zur Messung erforderlich sind, wie beispielsweise auch Triggersignale, wobei die Verarbeitung eines gemessenen Signals ausschließlich in dem Messgerätmodul erfolgt. Der daraus ermittelte Datensatz kann dann in anderen Meßgerätmodulen oder auch externen Recheneinheiten weiterverarbeitet werden oder über eine Anzeigevorrichtung dargestellt werden.

Das Messgerätmodul 35 ist dagegen als Rechnermodul ausgeführt und steht über die Kontaktleiste 55 mit der Informationsausgabeeinrichtung 9 in Verbindung. Das Rechnermodul steuert dabei den gemeinsam von dem Messgerätmodul 36 sowie dem Rechnermodul benutzten USB-Bus. Auf der zu der Rückseite des Messgeräts 1 gewandten Seite ist an dem Messgerätmodul 35 unter anderem eine Anschlussmöglichkeit 58 für ein zusätzliches Bildschirmgerät vorgesehen.

An dem zwischen dem Messgerätmodul 35 und dem Messgerätmodul 36 angeordneten Blindelement 37 sind beidseitig in Richtung der Messgerätmodule 35 und 36 Lamellen 59 ausgebildet, welche sich bei in das Messgerät 1 eingesteckten Messgerätmodulen 35 und 36 in dem rückwärtigen Bereich der Messgerätmodule 35 und 36 an die Messgerätmodule 35 und 36 anlegen, wobei die Lamellen 59 aus einem leitendem Material gefertigt sind, so dass sie zur Abschirmung des in der Aufnahmevorrichtung 10 angeordneten Messgerätmodule 35 und 36 beitragen. An dem zwischen dem Messgerätmodul 36 und der Seitenwand der Aufnahmevorrichtung 10 angeordneten Blindelement 38 sind ebenfalls Lamellen 59 beidseitig ausgebildet, welche zu einer Abschirmung von elektromagnetischer Strahlung dienen. Die Lamellen 59 der Blindelementen 37 und 38 wirken dabei mit entsprechenden Lamellen zusammen, welche an dem jeweiligen Messgerätmodul 35 bzw. 36 ausgebildet sind, und die im Zusammenhang mit dem Aufbau der Messgerätmodule 35 bzw. 36 noch näher erläutert werden.

Die Lamellen sind in Form von flachen Metallbügeln ausgeführt, die sich elastisch verformen lassen und damit einen sicheren Kontakt zu dem benachbarten Bauteil herstellen.

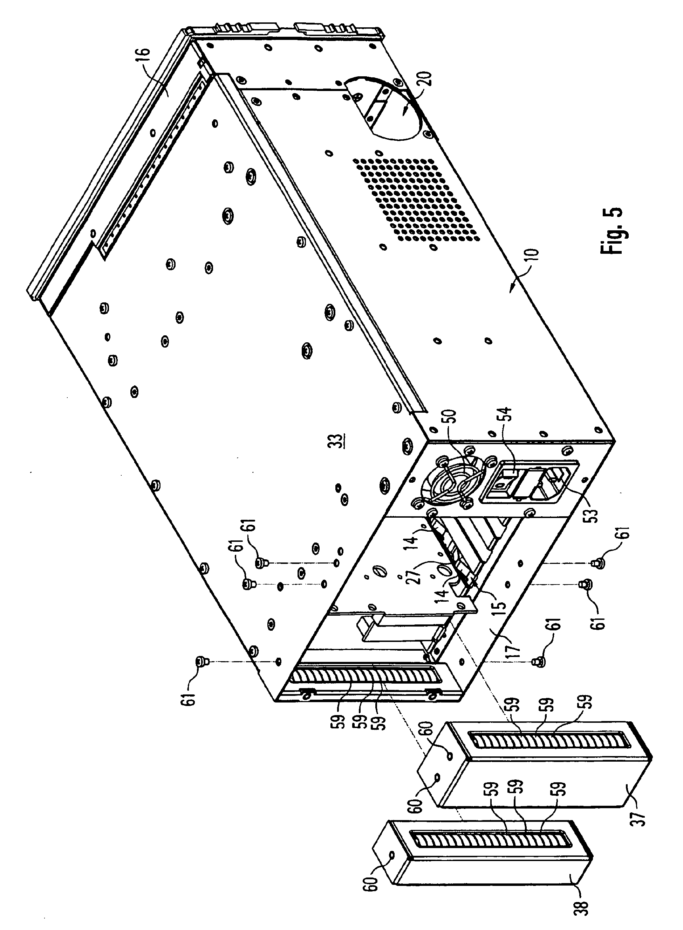

In Fig. 5 ist noch einmal die Aufnahmevorrichtung 10 gezeigt, wobei die Blindelemente 37 und 38 herausgenommen dargestellt sind. In den Blindelementen 37 und 38 sind zum Boden 17 der Aufnahmevorrichtung sowie zur Abdeckung 33 hin Gewindebohrungen 60 vorgesehen, so dass die Blindelemente 37 und 38 mit der Abdeckung 33 bzw. dem Boden 17 der Aufnahmevorrichtung 10 verschraubt werden können. Hierzu werden durch den Boden 17 der Aufnahmevorrichtung 10 sowie die Abdeckung 33 Schrauben 61 in die entsprechenden Gewindebohrungen 60 eingeschraubt.

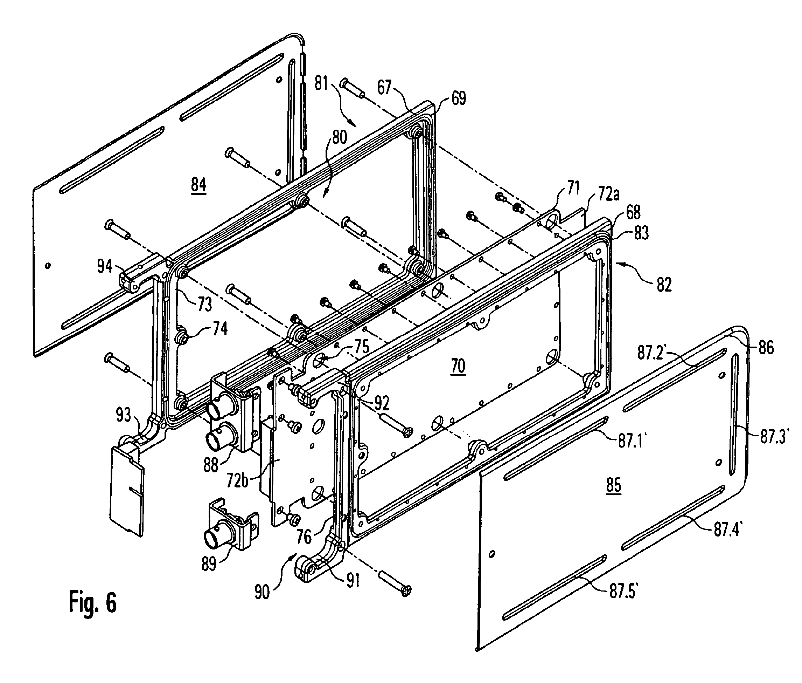

In Fig. 6 ist ein erstes Ausführungsbeispiel für den Aufbau eines erfindungsgemäßen Messgerätmoduls dargestellt. Als tragende Bauteile des Messgerätmoduls dienen ein erstes Rahmenelement 67 und ein zweites Rahmenelement 68. Die beiden Rahmenelemente 67 und 68 sind im wesentlichen rechteckig, wobei das erste Rahmenelement 67 an seiner dem zweiten Rahmenelement 68 zugewandten Seite eine Nut 69 aufweist, in die eine Hochfrequenzdichtschnur eingelegt wird. Das erste Rahmenelement 67 und das zweite Rahmenelement 68 sind entlang dieser Nut 69 so miteinander zu verbinden, dass sich entlang der Nut 69 aus dem ersten Rahmenelement 67 und dem zweiten Rahmenelement 68 ein geschlossener Grundrahmen ergibt. Innerhalb dieses Grundrahmens ist eine Hauptleiterplatte 70 angeordnet.

Zum Aufnehmen der Hauptleiterplatte 70 weist das erste Rahmenelement 67 einen an dem inneren Umfang des Rahmenelements 67 angeordnetes Aufnahmeelement 73 auf, auf das die Hauptleiterplatte 70 aufgelegt wird. An dem Aufnahmeelement 73 sind vorzugsweise sind Zentrierelemente 74 angebracht, welche die Position der Hauptleiterplatte 70 relativ zu dem ersten Rahmenelement 67 festlegen. Die Zentrierelemente 74 sind dabei vorzugsweise zylindrisch und mehrstufig ausgebildet, und greifen mit zumindest einer Stufe in entsprechende Zentrierausnehmungen 75 in die Hauptleiterplatte 70 ein.

Weiterhin sind an der Hauptleiterplatte 70 ein erster Fortsatz 72a sowie ein zweiter Fortsatz 72b ausgebildet, welche über den innerhalb der umlaufenden Nut 69 ausgebildeten ersten Leiterplattenraum 80 herausragen. Zur Durchführung des zweiten Fortsatzes 72b ist in dem zweiten Rahmenelement 68 eine gefräste Ausnehmung 76 vorgesehen, welche bei zusammengefügtem ersten Rahmenelement 67 und zweiten Rahmenelement 68 einen Schlitz zwischen den beiden Rahmenelementen 67 und 68 freigibt, welche geringfügig größer ist als die Dicke der Hauptleiterplatte 70. Eine entsprechende, in der Fig. nicht sichtbare Ausfräsung ist für den ersten Fortsatz 72a an dem zweiten Rahmenelement 68 ausgebildet. Der Fortsatz 72a wird durch die Ausfräsung herausgeführt und bildet die Kontaktleiste 55.

Das erste Rahmenelement 67 und das zweite Rahmenelement 68 bilden gemeinsam einen Grundrahmen, wobei die Hauptleiterplatte 70 in diesen Grundrahmen eingespannt ist. Das erste Rahmenelement 67 und das zweite Rahmenelement 68 fixieren die Leiterplatte 70 dabei entlang des äußeren Umfangs 71 der Hauptleiterplatte 70, wobei der größte Teil der Fläche der Hauptleiterplatte 70 durch die Rahmenelemente 67 und 68 nicht abgedeckt wird. Der so erzeugte Grundrahmen weist an seinen voneinander abgewandten Seiten 81 und 82 jeweils eine umlaufende Erhöhung 83 auf, welche zur Fixierung von auf den Grundrahmen aufzusetzenden Deckelplatten 84 und 85 dient.

Die Deckelplatten 84 und 85 verschließen den Grundrahmen und bilden damit einen abgeschlossenen ersten Leiterplattenraum 68 aus, in dem der größte Teil der Hauptleiterplatte 70 angeordnet ist. Da die Deckelplatten 84 und 85 ebenso wie das erste Rahmenelement 67 und das zweite Rahmenelement 68 aus einem metallischen Werkstoff gefertigt sind, werden die im Inneren angeordneten elektronischen Bauelemente dadurch vor elektromagnetischer Einstrahlung geschützt. Die Deckelplatten 84 und 85 sind identisch aufgebaut, so dass die nachfolgende Beschreibung sich lediglich auf die im Vordergrund dargestellte Deckelplatte 85 beschränkt.

Die Deckelplatte 85 weist an ihrem Rand 86 eine näherungsweise 90° betragende Umformung in Richtung des zweiten Rahmenelements 68 auf. Die Umformung ist in ihrer Außenkontur korrespondierend mit der umlaufenden Erhöhung 83 des zweiten Rahmenelement 68. Die Umformung an dem äußeren Rand 86 erstreckt sich ebenso wie die umlaufende Erhöhung 83 über drei Seiten der rechteckigen Grundgeometrie. Parallel zu der Umformung an dem Rand 86 der Deckelplatte 85 sind mehrere Sicken 87.1 bis 87.5 in die Deckelplatte 85 eingebracht, wobei die Sicken 87.1 bis 87.5 als Vertiefungen ebenfalls in Richtung der Umformung des Randes 86 der Deckelplatte 85 orientiert sind.

An dem aus dem ersten Leiterplattenraum 80 herausragenden zweiten Fortsatz 72b der Hauptleiterplatte 70 sind ein erstes Anschlusselement 88 und ein zweites Anschlußelement 89 zur Kontaktierung der Hauptleiterplatte 70 angeordnet. Der zweite Fortsatz 72b erstreckt sich dabei durch die Ausfräsung 76 aus dem ersten Leiterplattenraum 80 in einen zweiten Leiterplattenraum 90 hinein. Der zweite Leiterplattenraum 90 wird durch an dem ersten Rahmenelement 67 sowie dem zweiten Rahmenelement 68 vorgesehene Rahmenarme 91 bis 94 aufgespannt. Die zueinander gewandten Oberflächen der Rahmenarme 91 bis 94 liegen dabei wiederum Plan aneinander an, wenn das erste Rahmenelement 67 mit dem zweiten Rahmenelement 68 verbunden ist.

Durch den Grundrahmen, bestehend aus dem ersten Rahmenelement 67 und dem zweiten Rahmenelement 68, werden daher ein erster Leiterplattenraum 80 sowie ein zweiter Leiterplattenraum 90 gebildet, wobei der erste Leiterplattenraum 80 zu beiden Seiten der Hauptleiterplatte 70 durch jeweils eine Deckelplatte 84 und 85 verschlossen ist. In den zweiten Leiterplattenraum 90 ragt ein zweiter Fortsatz 72b der Hauptleiterplatte 70. Zur Durchführung der Hauptleiterplatte 70 in den zweiten Leiterplattenraum 90 ist eine Ausfräsung 76 vorgesehen, über die der erste Leiterplattenraum 80 mit dem zweiten Leiterplattenraum 90 verbunden ist. In dem zweiten Leiterplattenraum 90 ist in dem dargestellten Ausführungsbeispiel ein Anschlusselement 88 und ein zweites Anschlusselement 89 mit den Leiterbahnen der Hauptleiterplatte 70 verbunden. An der gegenüberliegenden Schmalseite des Messgerätmoduls ist ebenfalls eine Ausfräsung vorgesehen, durch welche der erste Fortsatz 72a aus dem ersten Leiterplattenraum 80 herausragt, wobei der Fortsatz 72a als Kontaktleiste ausgebildet ist, welcher in einer der Steckerbuchsen 12a bis 12e bzw. 27a oder 27b eingesteckt werden kann.

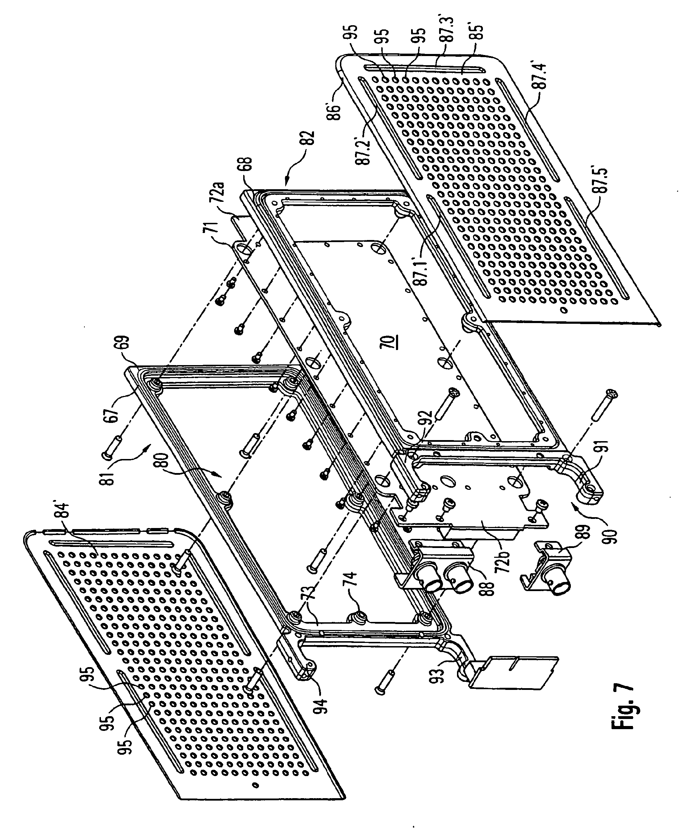

Das in Fig. 7 dargestellte Messgerätmodul entspricht in seinem Aufbau im wesentlichen dem in Fig. 6 dargestellten Messgerätmodul. An Stelle der Deckelplatten 84 und 85 sind jedoch Deckelplatten 84' und 85' vorgesehen, welche zur besseren Kühlung der auf der Hauptleiterplatte 70 angeordneten elektronischen Bauelemente mit Kühlluftöffnungen 95 durchbrochen sind. Um weiterhin eine ausreichende Schirmung sicherzustellen, sind auf der Hauptleiterplatte metallische Abdeckungen aufgebracht, die eine elektromagnetische Störung verhindern.

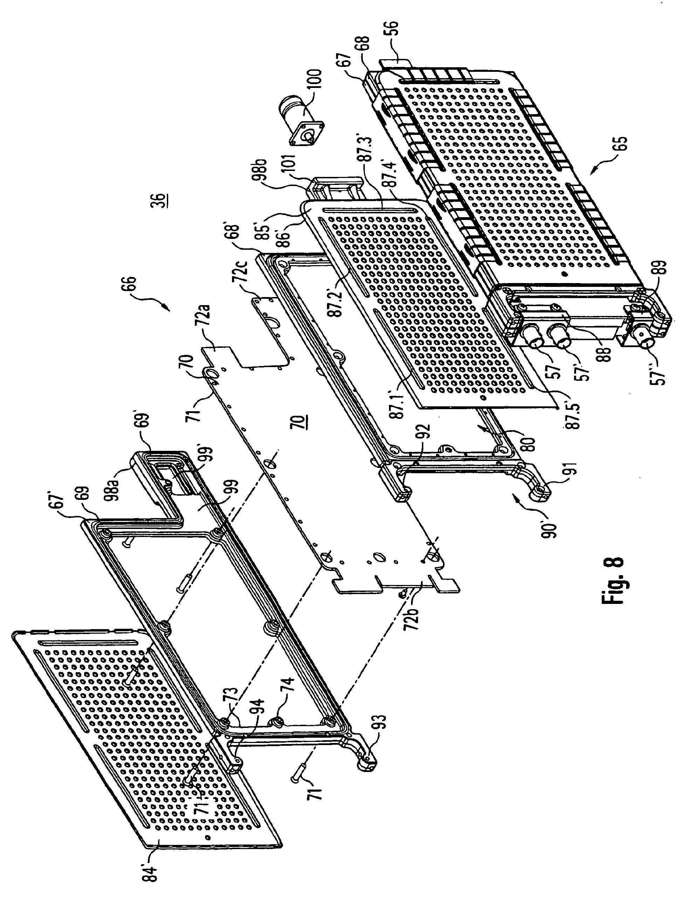

In Fig. 8 ist eine weitere vorteilhafte Ausführungsform eines erfindungsgemäßen Messgerätmoduls 36 dargestellt. Die Hauptleiterplatte 70 weist dabei einen dritten Fortsatz 72c auf. Korrespondierend zu der geometrischen Ausdehnung des dritten Fortsatzes 72c ist an dem ersten Rahmenelement 67' und dem zweiten Rahmenelement 68' ein Anschlussträger 98 ausgebildet. An dem ersten Rahmenelement 67' ist hierzu ein erstes Anschlussträgerelement 98a ausgebildet. Entlang des äußeren Rands des ersten Rahmenelement 67' ist wiederum eine umlaufenden Nut 69' ausgebildet, welche auch entlang der Außenkontur des ersten Anschlussträgerelements 98a verläuft. Weiterhin ist im Bereich des ersten Anschlussträgerelements 68a auf der zu der Deckelplatte 84' hin orientierten Seite des Rahmenelements 67' eine geschlossene Grundfläche 99 ausgebildet.

An dem zweiten Rahmenelement 68' ist korrespondierend zu dem ersten Anschlussträgerelement 98a ein zweites Anschlussträgerelement 98b vorgesehen, welches ebenfalls eine in der Fig. jedoch nicht sichtbare Grundfläche aufweist, so dass der dritten Fortsatz 72c der Hauptleiterplatte 70 von dem Anschlussträger 98 geschlossen umgeben ist, wenn das erste Rahmenelement 67' und das zweite Rahmenelement 68' zu einem Grundrahmen zusammengesetzt sind. Während in dem Übergangsbereich zwischen dem ersten Leiterplattenraum 80 und dem Anschlussträger 98 ein möglichst kleiner Spalt zur Durchführung des dritten Fortsatzes 72c ausgebildet ist, ist an dem von dem ersten Leiterplattenraum abgewandten Ende des Anschlussträger 98 durch eine Abstufung der Grundfläche 99 ein vergrößerter Freiraum 99' ausgebildet, in dem ausreichend Platz vorhanden ist, um eine Kontaktierung der Hauptleiterplatte 70 an dem dritten Fortsatz 72c durch einen elektrischen Anschluss 100 vorzusehen.

Der elektrische Anschluss 100 wird auf die Stirnseite des Anschlussträger 98 geschraubt, wobei im dargestellten Ausführungsbeispiel an dem zweiten Anschlussträgerelement 98b eine zusätzliche Befestigungsfläche 101 ausgebildet ist. In Abhängigkeit von der Einbaulage des entsprechenden Messgerätmoduls in dem Messgerät 1 kann die zusätzliche Befestigungsfläche 101 auch an dem ersten Anschlussträgerelement 98a ausgebildet sein.

In der Fig. 8 dargestellt ist das Messgerätmodul 36 aus Fig. 4. Das Messgerätmodul 36 wird dabei aus zwei Grundelementen 65 und 66 zusammengesetzt, wobei das Grundelement 65 dem in Fig. 7 beschriebenen Grundelement entspricht. Zusätzlich vorhanden ist das Grundelement 66, welches mit dem Grundelement 65 im Bereich der Rahmenarme 91 und 92 verbunden ist. Die Rahmenarme 91 bis 94 sind dicker als der den ersten Leiterplattenraum 80 umgebende Teil des ersten Rahmenelements 67' und des zweiten Rahmenelements 68', so dass die Rahmenarme 91 und 92 in Anlage mit den Rahmenarmen 93 und 94 des Grundelements 65 gebracht werden können. Die Rahmenarme 91 bis 94 des Grundelements 66 spannen daher gemeinsam mit den Rahmenarmen 91 bis 94 des Grundelements 65 einen gemeinsamen Bauraum auf, der als Hilfsleiterplattenraum 90' bezeichnet wird.

In diesem Hilfsleiterplattenraum 90' kann beispielsweise eine nicht dargestellte Hilfsleiterplatte angeordnet sein, welche der Verbindung der Hauptleiterplatte 70 des Grundelements 66 mit einer weiteren Hauptleiterplatte 70 des Grundelements 65 dient.

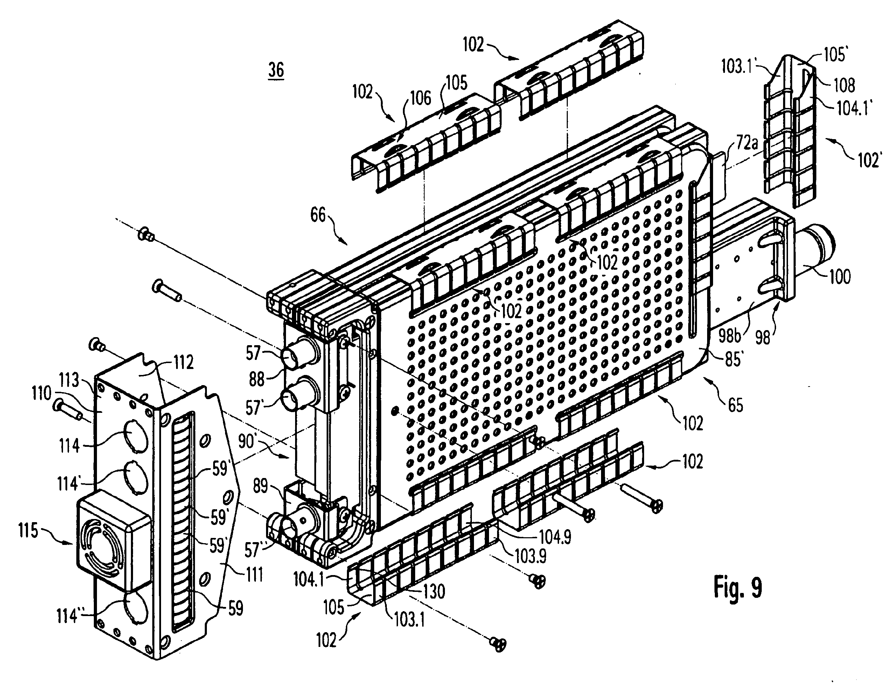

In Fig. 9 ist noch einmal das Messgerätmodul 36 dargestellt, wobei die beiden Grundelemente 65 und 66 bereits zusammengesetzt dargestellt sind. Während die Rahmenelemente 67 und 68 bzw. 67' und 68' miteinander verschraubt werden, sind die Deckelplatten 84' und 85' lediglich aufgesetzt. Gegen ein Verschieben auf dem jeweiligen Grundrahmen sind, wie bereits beschrieben wurde, die äußeren Ränder 86 der Deckelplatten so umgeformt, dass sie eine entsprechende Erhöhung 83, die an dem jeweiligen Rahmenelement 67, 68, 67' oder 68' ausgebildet ist, umgreifen. Zur Fixierung der Deckelplatten 84' und 85' an den Grundrahmen der Grundelemente 65 und 66 sind Klammerelemente 102 vorgesehen.

Die Klammerelemente 102 sind als U-Profil ausgebildet, welches sich über eine Länge erstreckt, die höchstens gleich der Länge der Sicken 87.1 bis 87.5 ist. Die beiden Schenkel des U-Profils werden dabei aus einer Reihe von einzelnen Federlaschen 103.1 bis 103.9 bzw. auf der gegenüberliegenden Seite 104.1 bis 104.9 gebildet. Die Federlaschen 103.1 bis 103.9 und 104.1 bis 104.9 sind gemeinsam an einer Trägerfläche 105 angeordnet. Die Breite der Trägerfläche 105 ergibt sich dabei aus der Breite des Grundrahmens.

Entgegengesetzt zu der Richtung, in der sich die Federlaschen 103.1 bis 103.9 und 104.1 bis 104.9 von der Trägerfläche 105 erstrecken, sind als Führungselement ein Paar bogenförmige Ausprägungen 106 an der Trägerfläche 105 vorgesehen. Der Abstand der einander zugewandten Flanken der bogenförmigen Ausprägungen 106 ist dabei geringfügig größer als die seitliche Ausdehnung der Federzungen 14. Der Abstand der voneinander abgewandten Flanken der bogenförmigen Ausprägungen 106 dagegen korrespondiert mit der Breite der Nut 27, welche an dem Boden 17 der Aufnahmevorrichtung 10 angeordnet ist. Die jeweils paarweise an der Trägerfläche 105 der Klemmelemente 102 angeordnete bogenförmige Ausprägung 106 wirkt damit mit der Führungseinrichtung 15 der Aufnahmevorrichtung 10 zu einer Führungsvorrichtung für das jeweilige Messgerätmodul zusammen.

Die Klemmelemente 102 werden vom äußeren Umfang soweit über die an dem Grundrahmen anliegenden Deckelplatten 84' und 85' geschoben, bis Rastnasen 107, die an jeder Federlasche 103.1 bis 103.9 sowie 104.1 bis 104.9 an dem von der Trägerfläche 105 abgewandten Ende angeordnet sind, in die Sicken 87.1 bis 87.5 einschnappen. Die Länge der Federlaschen 103.1 bis 103.9 und 104.1 bis 104.9 ist dabei so bemessen, dass die Trägerfläche 105 an dem Grundrahmen anliegt. Dadurch wird gewährleistet, dass die von den Federzungen 14 auf das Messgerätmodul übertragene Kraft tatsächlich auf das Messgerätmodul übertragene wird, und nicht lediglich zu einem Verschieben der Klemmelemente 102 auf dem Grundelement führt.

An der der Vorderseite des Messgeräts 1 zugewandten Seite eines Grundelements ist ebenfalls ein Klemmelement 102' angeordnet, welches in seiner Trägerfläche 105' einen Schlitz 108 aufweist durch den der Fortsatz 72a der Hauptleiterplatte 70 hindurch ragt. Aufgrund des Anschlussträgers 98 ist das Klemmelement 102' kürzer als die übrigen Klemmelemente 102. Um weiterhin den Schlitz 108 geschlossen von der Trägerfläche 105' umgeben zu können, ist die jeweils erste Federlasche 103.1' und 104.1' abgeschrägt ausgeführt.

Auf der gegenüberliegenden Seite des Messgerätmoduls 36 wird der offene Hilfsleiterplattenraum 90', in dem das erste Anschlusselement 88 und das zweite Anschlusselement 89 mit dem zweiten Fortsatz 72b der Hauptleiterplatte 70 des Grundelements 65 verschraubt ist, mit einem Gehäusedeckel 110 verschlossen. Der Gehäusedeckel 110 deckt dabei drei Seiten von dem durch die Rahmenarme 91 bis 94 des Grundelements 65 sowie die Rahmenarme 91 bis 94 des Grundelements 66 aufgespannten Hilfsleiterplattenraum 90' ab. Dabei weist der Gehäusedeckel 110 seitliche Wangen 111 und 112 auf, deren Ausdehnung in Richtung des elektrischen Anschlusses 100 größer sind als die Länge der Rahmenarme 91 bis 94. Dadurch überlappt die seitliche Wange 111 die Deckelplatte 85' und die seitliche Wange 112 die Deckelplatte 84'. Die Deckelplatte 84' und 85' wird dann gemeinsam mit den seitlichen Wangen 111 bzw. 112 mit jeweils einem Rahmenelement verschraubt. Damit ist über die gemeinsame Verschraubung der seitlichen Wangen 111 und 112 mit den jeweiligen Deckelplatten 84' und 85' sichergestellt, dass auch in dem Bereich, in dem die Deckelplatten 84' und 85' nicht mit einem Klemmelemente 102 fixiert werden können, eine Anlage zu dem jeweiligen Grundelement sichergestellt ist.

Weiterhin ist in der seitliche Wange 111 ein Bereich vorgesehen, in dem die schon von den Blindelementen 37 und 38 bekannten Lamellen 59 angeordnet sind. Die seitlichen Wangen 111 und 112 sind über eine Rückwand 113 miteinander verbunden, wobei in der Rückwand 113 Anschlussöffnungen 114, 114' und 114'' vorhanden sind, durch welche bei Aufsetzen des Gehäusedeckels 110 auf das Messgerätmodul 36 die elektrischen Anschlüsse 57, 57' sowie 57" aus dem Gehäusedeckel 110 herausragen.

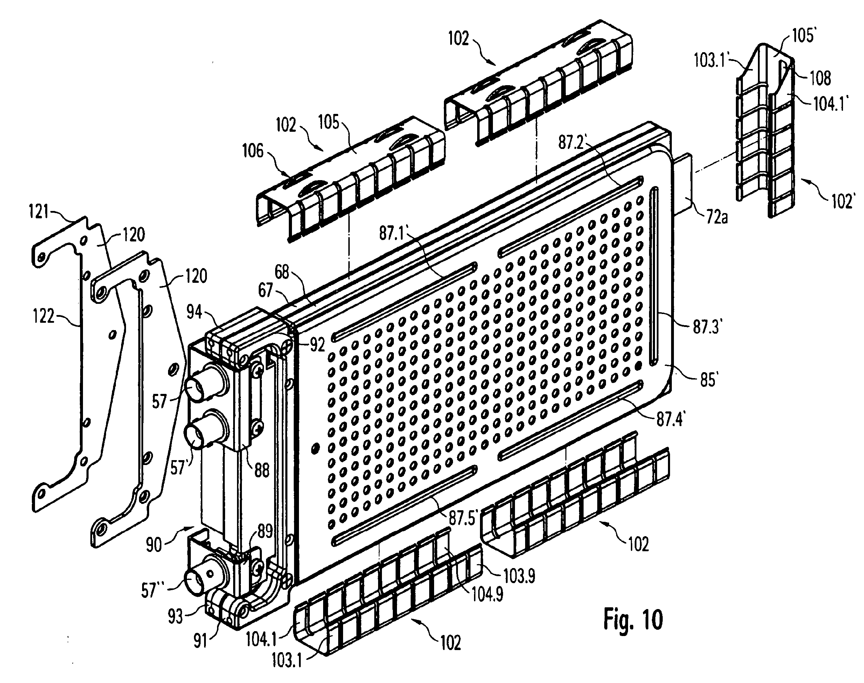

Im dargestellten Ausführungsbeispiel ist zudem an dem Gehäusedeckel 110 ein weiterer Lüfter 115 vorgesehen, welcher zur Erhöhung des Luftstromes im Bereich der Grundelemente 65 und 66 dient. Zwischen den einander zugewandten Deckelplatten 85' des Grundelements 66 und der Deckelplatte 84' des Grundelements 65 ist ein Abstand vorhanden, welcher ein Durchströmen mit Kühlluft ermöglicht. Um einen solchen Abstand, dessen Größe durch das Rastermaß der Führungseinrichtungen 15 in der Aufnahmevorrichtung 10 festgelegt ist, herzustellen, sind zwischen den Grundelementen 65 und 66 im Bereich der Rahmenarme 91 und 92 des Grundelements 66 und der Rahmenarme 93 und 94 des Grundelements 65 Abstandselemente vorgesehen, welche unter Bezugnahme auf Fig. 10 erläutert werden.

Im einfachsten Fall wird ein Messgerätmodul durch ein einzelnes Grundelement dargestellt, wie es in der Fig. 10 gezeigt ist. Das Rastermaß, in dem in der Aufnahmevorrichtung 10 die Führungseinrichtungen 15 angeordnet sind, wird durch die Baubreite eines solchen Messgerätmoduls bestimmt. Wie bereits bei der Erläuterung zur Verbindung von mehr als einem Grundelement ausgeführt wurde, ist bei einem solchen Grundelement die größte Baubreite im Bereich der Rahmenarme 91 bis 94 gegeben.

Zu dieser Baubreite kommt die Materialdicke der seitlichen Wangen 111 und 112 des Gehäusedeckels 110 hinzu. Wird nun, wie dies bei dem in der Fig. 9 dargestellten Messgerätmodul gezeigt ist, das Messgerätmodul aus zwei Grundelementen zusammengesetzt, so entfallen wegen des gemeinsamen Gehäusedeckels 110 die seitlichen Wangen 111 bzw. 112, die zwischen den Rahmenarmen 91 bis 94 zweier Grundelemente angeordnet sind. Werden daher zwei Grundelemente zu einem Messgerätmodul zusammengesetzt, so werden zwischen die beiden Grundelemente zwei Abstandselemente 120 eingesetzt, so dass das Rastermaß gehalten wird.

Die Abstandselemente 120 weisen dabei eine Außenkontur 121 auf, welche der Außenkontur der seitlichen Wangen 111 bzw. 112 entspricht. Damit überlappt ein Teil der Abstandselemente 120 die entsprechende Deckelplatte 84' bzw. 85' der zu verbindenden Grundelemente 65 bzw. 66 so dass die entsprechenden Deckelplatten 84' bzw. 85' auch im Bereich des Übergangs zwischen dem ersten Leiterplattenraum 80 und dem Hilfsleiterplattenraum 90' fixiert sind. Ferner weisen die Abstandselemente 120 eine Innenkontur 122 auf, welche mit der durch die Rahmenelemente 67 und 68 gemeinsam mit den Rahmenarme 91 bis 94 ausgebildeten Innengeometrie des zweiten Leiterplattenraums 90 entspricht.

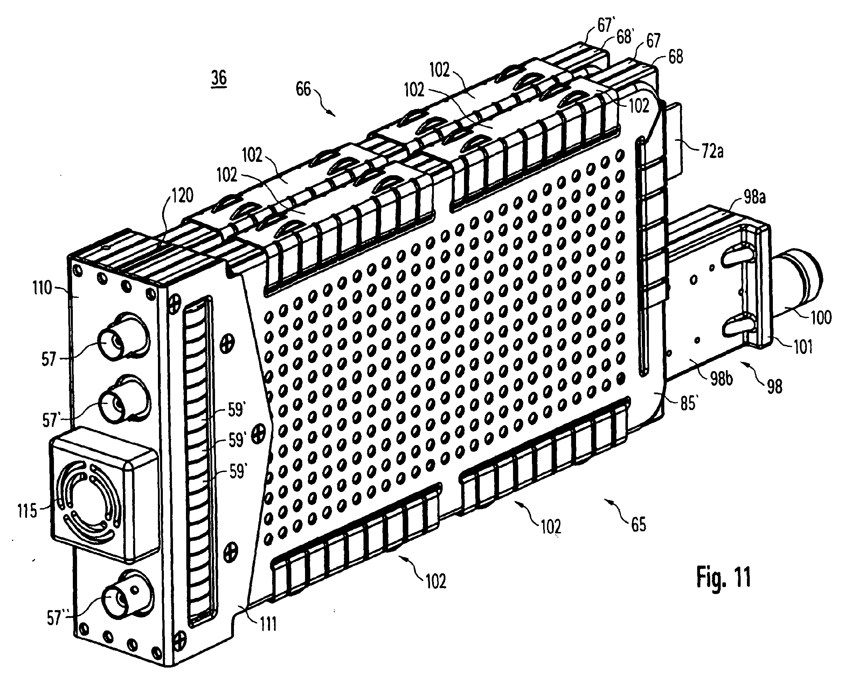

In Fig. 11 ist noch einmal das vollständige Messgerätmodul 36 dargestellt, dessen Aufbau anhand der Figuren 6 bis 10 ausführlich dargestellt wurde. Das Messgerätmodul 36 weist einen zur Vorderseite des Messgeräts 1 orientierten elektrischen Anschluss 100 auf, der z. B. als N- oder BNC-Buchse ausgebildet sein kann. An der zu der Rückseite des Messgeräts orientierten Seite des Messgerätmoduls 36 befinden sich drei elektrische Anschlüsse 57, 57' und 57'', welche als für Messgeräte übliche Anschlüsse ausgebildet sind. Das Messgerätmodul 36 verfügt damit sowohl in Richtung der Vorderseite des Messgeräts 1 als auch in Richtung der Rückseite des Messgeräts 1 über Anschlüsse, so dass bei einem einfachen Wechsel eines zu vermessenden Gerätes das Messgerät 1 ausschließlich von der Vorderseite her bedienbar bleibt.

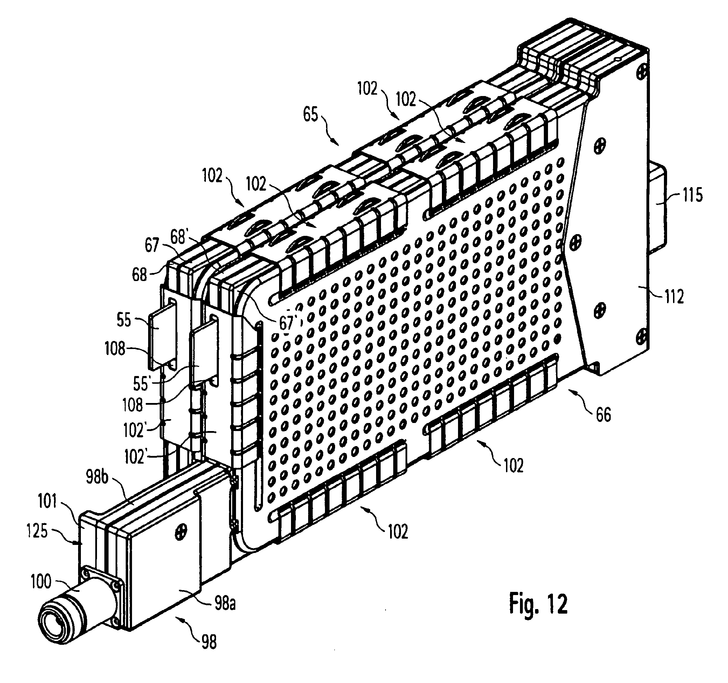

In Fig. 12 ist noch einmal die Vorderseite des Messgerätmoduls 36 gezeigt. Der elektrische Anschluss 100 ist an dem Anschlussträger 98 befestigt, der sich aus dem ersten Anschlussträgerelement 98a und dem zweiten Anschlussträgerelement 98b zusammengesetzt. Wie bereits bei der Beschreibung der Fig. 8 erläutert wurde, wird durch eine Abstufung der Grundfläche 99, welche die äußere Begrenzung des Anschlussträgers bildet, in Richtung des elektrischen Anschlusses 100 eine Vergrößerung des von dem Anschlussträger 98 umgebenen Volumens erreicht. Durch diese Verbreiterung des ersten Anschlussträgerelements 98a wird auch eine Montagefläche 125, die sich aus den Stirnseiten des ersten Anschlussträgerelements 98a und 98b zusammensetzt, vergrößert. Für eine solche Vergrößerung der Montagefläche 125 ist an dem zweiten Anschlussträgerelement 98b eine zusätzliche Befestigungsfläche 101 vorgesehen, welche lediglich zur Aufnahme des elektrischen Anschlusses 100 dient und eine Vergrößerung des inneren Volumens des Anschlussträgers 98 nicht zur Folge hat.

Je nachdem, in welchem Steckplatz das Messgerätmodul eingesetzt wird, kann auch das Anschlussträgerelement 98b die Abstufung zu Vergrößerung des Bauraums erhalten und an dem ersten Anschlussträgerelement 98a die zusätzliche Befestigungsfläche 101 ausgebildet sein. Aufgrund des erhöhten Platzbedarfs sind die Führungseinrichtungen 15, die der Aufnahme der Messgerätmodule dienen, welche einen Anschlussträger 98 aufweisen, mit einem größeren Abstand versehen.

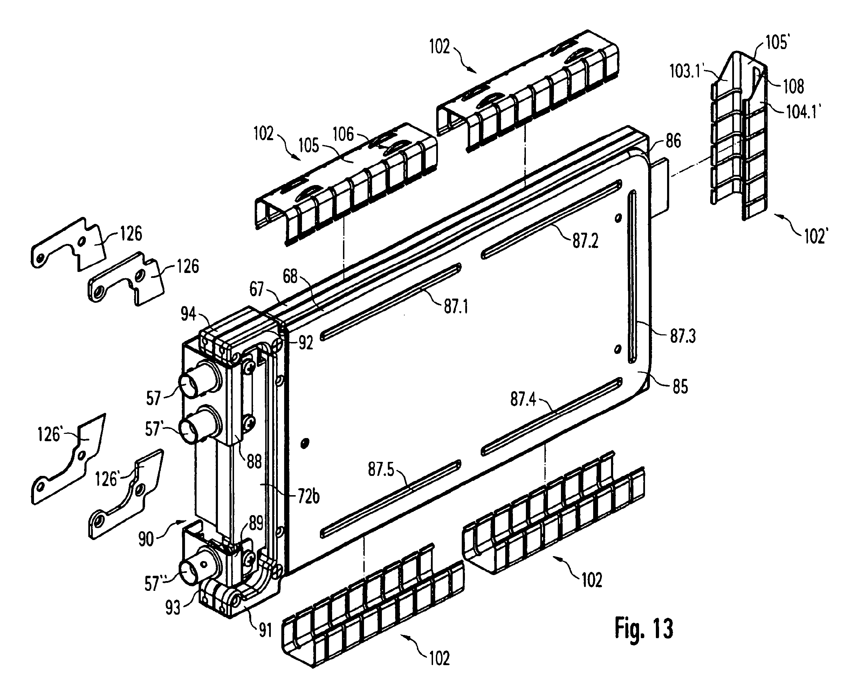

Zur Verbesserung des Kühlluftstroms können die Abstandselemente 120 auch zweiteilig ausgeführt sein. Solche zweiteilige Abstandselemente sind in der Fig. 13 mit den Bezugszeichen 126 und 126' versehen. Der Abstand der Grundelemente wird dabei lediglich im Bereich der Rahmenarme 91 bis 94 erzeugt, so dass der zwischen den Deckelplatten 84 und 85 eintretende Kühlluftstrom bis in den Bereich der Abstandselemente 126 und 126' gelangt, wo er in den Hilfsleiterplattenraum 90' einströmt. Insbesondere bei Einsatz eines zusätzlichen Lüfters 115 wird damit die Kühlung des Messgerätmoduls erheblich verbessert.

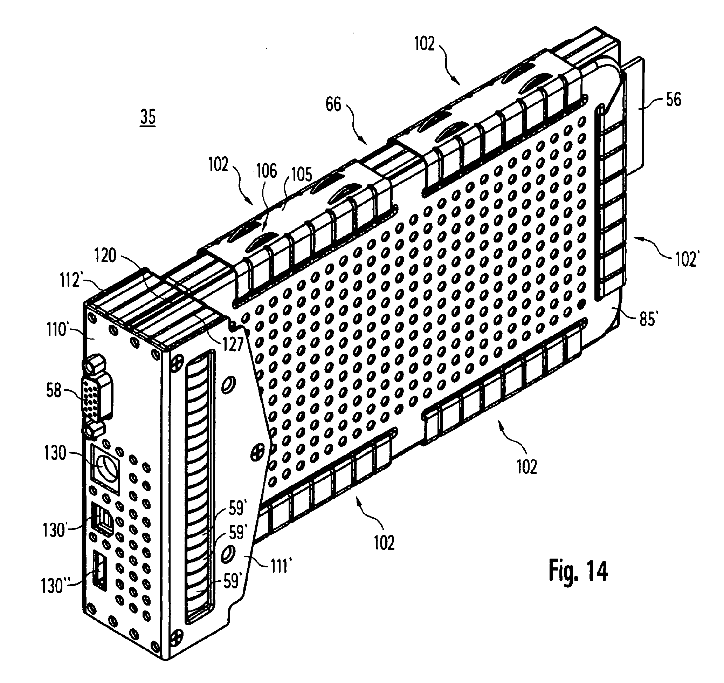

In Fig. 14 ist ein als Rechnermodul ausgebildetes Messgerätmodul 35 dargestellt. Das Messgerätmodul 35 besteht aus einem Grundelement 66' und ist an seiner der Rückseite des Messgeräts zugewandten Seite mit einem Rahmenkörper 127 verbunden, welcher den zweiten Leiterplattenraum 90 zu einem Hilfsleiterplattenraum 90' ergänzt. Der Rahmenkörper 127 entspricht in seiner Innengeometrie den Abstandselementen 120, wobei er jedoch eine Dicke aufweist, die der Breite der Rahmenarme 91 bis 94 eines Grundelements entspricht. Durch einen solchen Rahmenkörper 127 wird also ein Grundelement 66' so ergänzt, dass der von dem Messgerätmodul 36 bekannte Hilfsleiterplattenraum 90' entsteht, ohne dass ein vollständiges zweites Grundelement mit dem Grundelement 66' verbunden werden muss. Zwischen dem Grundelement 66' und dem Rahmenkörper 127 sind wiederum Abstandselemente 120 eingesetzt, so dass die gesamte Breite des Messgerätmoduls 35 wiederum ein Vielfaches des Rastermaßes ist.

Durch den Gehäusedeckel 110' ragen verschiedene Anschlüsse des Rechnermoduls heraus, zu denen unter anderem ein Videoanschluss zum Anschließen eines Bildschirmgeräts gehört. Weiterhin sind eine Reihe von zusätzlichen Anschlüssen 130, 131' und 130" vorgesehen, womit das Rechnermodul beispielsweise mit einem Netzwerk und zusätzlichen Ein- und Ausgabegeräten verbunden werden kann.

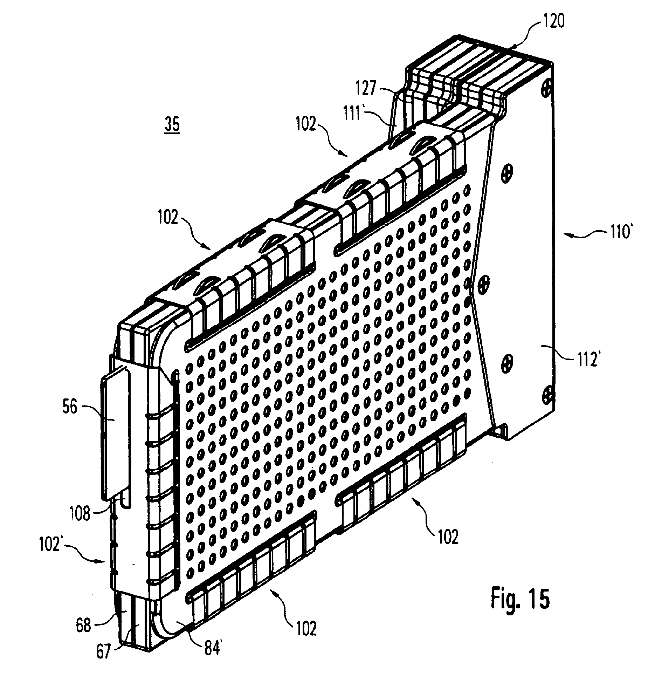

Fig. 15 zeigt das Rechnermodul 35 aus einer zweiten Perspektive. Dabei ist gut zuerkennen, wie der Rahmenkörper 127 die Baubreite im Bereich des zweiten Leiterplattenraums 90 so ergänzt, dass dort der Hilfsleiterplattenraum 90' ausgebildet wird. Dieser Hilfsleiterplattenraum 90' wird wiederum durch einen gemeinsamen Gehäusedeckel 110 geschlossen.

Beim Aufbau des Messgeräts 1 können auch zwei Rechnermodule vorgesehen sein, was nicht dargestellt ist. Das eine Rechnermodul ist dabei für die Kommunikation mit der Informationsausgabeeinrichtung 9 vorgesehen, wohingegen das zweite Rechnermodul zur Ansteuerung des Messgeräts 1 über externe Ein-/Ausgabevorrichtungen bzw. über ein Netzwerk, wie z. B. Ethernet, vorgesehen ist.

Die einzelnen Messgerätmodule bilden dabei vollständige Funktionseinheiten, die bei entsprechender Stromversorgung auch außerhalb des Messgeräts betrieben werden können. Dies hat den Vorteil, dass eine Kalibrierung eines einzelnen Messgerätmoduls erfolgen kann, und die so kalibrierten Messgerätmodule untereinander ausgetauscht werden können. Insbesondere bei einem nachträglichen Austausch eines Messgerätmoduls, z. B. aufgrund eines Defekts, werden damit erheblich Kosten eingespart.

## Patentansprüche

1. Messgerät mit einsteckbaren Messgerätmodulen (35, 36), die über eine Steckerplatte (11) mit einer Informationsausgabeeinrichtung (9) an einer Vorderseite des Messgeräts (1) verbunden sind, wobei die Messgerätmodule (35, 36) von einer von der Informationsausgabeeinrichtung (9) abgewandten Rückseite einsteckbar sind,
**dadurch gekennzeichnet,**
**dass** in der Vorderseite des Messgeräts (1) eine Aussparung (5) vorgesehen ist, über die zumindest für einen Teil der eingesteckten Messgerätmodule (35, 36) ein elektrischer Anschluss (6) zugänglich ist und
**dass** für jedes aufzunehmende Messgerätmodul (35, 36) zumindest eine Führungseinrichtung (15) zur Führung der Messgerätmodule vorgesehen ist, wobei die zumindest eine Führungseinrichtung (15) zur federnden Lagerung der Messgerätmodule (35, 36) ein elastisch verformbares Führungselement aufweist.

2. Messgerät nach Anspruch 1,
**dadurch gekennzeichnet,**
**dass** zumindest ein Teil der Messgerätmodule (35, 36) elektrische Anschlüsse (57, 57', 57'', 58, 130, 130'') aufweist, die von der Rückseite des Messgeräts (1) zugänglich sind.

3. Messgerät nach Anspruch 1,
**dadurch gekennzeichnet,**
**dass** die Führungseinrichtungen (15) für benachbarte Messgerätmodule (35, 36) so beabstandet sind, dass zwischen benachbarten Messgerätmodulen (35, 36) ein Kühlluftspalt ausgebildet ist.

4. Messgerät nach Anspruch 2 oder 3,
**dadurch gekennzeichnet,**
**dass** die elastisch verformbaren Führungselemente von in einer Reihe angeordneten Federzungen (14) gebildet werden.

5. Messgerät nach einem der Ansprüche 1 bis 4,
**dadurch gekennzeichnet,**
**dass** die Steckerplatte (11) in zumindest einer Ebene senkrecht zur Einschubrichtung der Messgerätmodule (35, 36) verschiebbar in einer Aufnahmevorrichtung (10) gelagert ist.

6. Messgerät nach einem der Ansprüche 1 bis 5,
**dadurch gekennzeichnet,**
**dass** zur Fixierung der Messgerätmodule (35, 36) ein rückseitiger Messgerätgehäusedeckel (41) vorgesehen ist, der zumindest eine Aussparung (42) aufweist, durch die zur Gehäuserückseite orientierte Anschlüsse der Messgerätmodule (35, 36) zugänglich sind.

7. Messgerät nach Anspruch 6,
**dadurch gekennzeichnet,**
**dass** zur Abdeckung der Kühlluftspalte zwischen den Messgerätmodulen (35, 36) und/oder Blindelementen (37, 38) Einlegeelemente (45) in den Messgerätgehäusedeckel (41)einsetzbar sind.

8. Messgerät nach einem der Ansprüche 1 bis 7,
**dadurch gekennzeichnet,**
**dass** jeweils ein Messgerätmodul (35, 36) als eine Funktionseinheit ausgebildet ist und ein Datentransfer zwischen verschiedenen Messgerätmodulen (35, 36) oder zu der Informationsausgabeeinrichtung (9) über ein Bussystem durchführbar ist.

9. Messgerät nach Anspruch 8,
**dadurch gekennzeichnet,**
**dass** die Informationsausgabeeinrichtung (9) als Ein-/Ausgabeeinrichtung ausgebildet ist.

10. Messgerät nach Anspruch 8 oder 9,
**dadurch gekennzeichnet,**
**dass** zumindest ein Messgerätmodul (35) als Rechnermodul zur Regelung des Datentransfers über das Bussystem ausgebildet ist.

11. Messgerät nach einem der Ansprüche 8 bis 10,
**dadurch gekennzeichnet,**
**dass** ein einsteckbares Netzmodul vorgesehen ist, welches ebenfalls mit der Steckerplatte (11) über eine elektrische Steckverbindung (13) verbunden ist, wobei die Versorgung der Messgerätmodule (35, 36) über das Bussystem erfolgt.

## Claims

1. Measuring device with plug-in measuring-device modules (35, 36), which are connected via a plug-and-socket panel (11) at a front side of the measuring device (1) to an information-output device (9), wherein the measuring-device modules (35, 36) can be plugged in from a rear side facing away from the information-output device (9),
**characterised in that**
a recess (5) is provided in the front side of the measuring device (1), through which an electrical connection (6) for at least some of the plug-in measuring-device modules (35, 36) is accessible, and that at least one guide device (15) for guiding the measuring-device modules is provided for each measuring-device module (35, 36) to be accommodated, wherein the at least one guide device (15) provides a guide element capable of resilient deformation for the resilient mounting of the measuring-device modules (35, 36).

2. Measuring device according to claim 1,
**characterised in that**
at least some of the measuring-device modules (35, 36) provide electrical connections (57, 57', 57 " , 58, 130, 130 "), which are accessible from the rear side of the measuring device (1).

3. Measuring device according to claim 1,
**characterised in that**
the guide devices (15) for adjacent measuring-device modules (35, 36) are spaced in such a manner that a cooling-air gap is formed between adjacent measuring-device modules (35, 36).

4. Measuring device according to claim 2 or 3,
**characterised in that**
the guide elements capable of resilient deformation are formed by resilient tongues (14) arranged in a row.

5. Measuring device according to any one of claims 1 to 4,
**characterised in that**
the plug-and-socket panel (11) is mounted within a receiving device (10) in such a manner that it is displaceable in at least one plane perpendicular to the plug-in direction of the measuring-device modules (35, 36).

6. Measuring device according to any one of claims 1 to 5,
**characterised in that**
a rear cover (41) of the measuring-device housing, which provides at least one opening (42), through which connections of the measuring-device modules (35, 36) orientated towards the rear side of the housing are accessible, is provided in order to fix the measuring-device modules (35, 36).

7. Measuring device according to claim 6,
**characterised in that**
insert elements (45) can be inserted in the rear cover (41) of the measuring-device housing in order to cover the cooling-air gaps between the measuring-device modules (35, 36) and/or unapertured-face elements (37, 38).

8. Measuring device according to any one of claims 1 to 7,
**characterised in that**
each measuring-device module (35, 36) is formed as a functional unit, and a data transfer either between different measuring-device modules (35, 36) or to the information-output device (9) can be implemented via a bus system.

9. Measuring device according to claim 8,
**characterised in that**
the information-output device (9) is formed as an input/output device.

10. Measuring device according to claim 8 or 9,
**characterised in that**
at least one measuring-device module (35) is designed as a computer module for controlling the data transfer via the bus system.

11. Measuring device according to any one of claims 8 to 10,
**characterised in that**
a plug-in power pack, which is also connected to the plug-and-socket panel (11) via an electrical plug connection (13), is provided, wherein the power supply of the measuring-device modules (35, 36) is implemented via the bus system.

## Revendications

1. Appareil de mesure avec des modules d'appareil de mesure enfichables (35, 36) qui sont reliés à un système d'édition d'informations (9) sur une face avant de l'appareil de mesure (1) par l'intermédiaire d'une plaquette à fiches (11), les modules d'appareil de mesure (35, 36) pouvant être enfichés par une face arrière opposée au système d'édition d'informations (9),
**caractérisé en ce que** dans la face avant de l'appareil de mesure (1) est prévu un évidement (5), lequel permet d'accéder à une connexion électrique (6) au moins pour une partie des modules d'appareil de mesure (35, 36) enfichés, et
**en ce que** pour chaque module d'appareil de mesure (35, 36) à recevoir, au moins un système de guidage (15) destiné à guider les modules d'appareil de mesure est prévu, le système de guidage (15) présentant un élément de guidage élastiquement déformable afin de loger élastiquement les modules d'appareil de mesure (35, 36).

2. Appareil de mesure selon la revendication 1, **caractérisé en ce qu'**au moins une partie des modules d'appareil de mesure (35, 36) présente des connexions électriques (57, 57', 57", 58, 130, 130") qui sont accessibles par la face arrière de l'appareil de mesure (1).

3. Appareil de mesure selon la revendication 1, **caractérisé en ce que** les systèmes de guidages (15) pour des modules d'appareil de mesure contigus (35, 36) sont espacés de telle manière qu'une fente destinée à de l'air de refroidissement est conçue entre des modules d'appareil de mesure contigus (35, 36).

4. Appareil de mesure selon la revendication 2 ou 3, **caractérisé en ce que** les éléments de guidage élastiquement déformables sont formés par des lames flexibles (14) disposées en série.

5. Appareil de mesure selon l'une quelconque des revendications 1 à 4, **caractérisé en ce que** la plaquette à fiches (11) est logée dans au moins un plan perpendiculairement au sens d'insertion des modules d'appareil de mesure (35, 36) de manière à pouvoir se déplacer dans un dispositif de réception (10).

6. Appareil de mesure selon l'une quelconque des revendications 1 à 5, **caractérisé en ce que** pour fixer les modules d'appareil de mesure (35, 36) est prévu un couvercle arrière de logement d'appareil de mesure (41) qui présente au moins un évidement (42), au travers duquel des connexions des modules d'appareil de mesure (35, 36) orientées vers l'arrière du logement sont accessibles.

7. Appareil de mesure selon la revendication 6, **caractérisé en ce que** pour recouvrir les fentes destinées à de l'air de refroidissement entre les modules d'appareil de mesure (35, 36) et/ou les éléments borgnes (37, 38), des éléments d'insertion (45) peuvent être insérés dans le couvercle arrière de logement de l'appareil de mesure (41).

8. Appareil de mesure selon l'une quelconque des revendications 1 à 7, **caractérisé en ce qu'**un module d'appareil de mesure (35, 36) est conçu respectivement comme une unité fonctionnelle et un transfert des données entre différents modules d'appareil de mesure (35, 36) ou vers le système d'édition d'informations (9) peut être réalisé par l'intermédiaire d'un système de bus.

9. Appareil de mesure selon la revendication 8, **caractérisé en ce que** le système d'édition d'informations (9) est conçu comme un système d'entrée/d'édition.

10. Appareil de mesure selon la revendication 8 ou 9, **caractérisé en ce qu'**au moins un module d'appareil de mesure (35) est conçu comme module informatique destiné à réguler le transfert des données par l'intermédiaire du système de bus.

11. Appareil de mesure selon l'une quelconque des revendications 8 à 10, **caractérisé en ce qu'**un module réseau enfichable est prévu, lequel est également relié à la plaquette à fiches (11) par l'intermédiaire d'un connecteur à fiches (13) électrique, l'alimentation des modules d'appareil de mesure (35, 36) étant effectuée par l'intermédiaire du système de bus.
